# EUROPÄISCHE PATENTSCHRIFT

(11) **EP 3 542 220 B1**
(45) Veröffentlichungstag und Bekanntmachung des Hinweises auf die Patenterteilung: **14.10.2020**
(21) Anmeldenummer: 17798234.5
(22) Anmeldetag: 16.11.2017
(51) Int. Cl.: G03F 1/82, G03F 7/20, G03F 1/66

(54) **HALTER ZUR AUFNAHME UND ZUM SCHUTZ EINER SEITE EINER PHOTOMASKE ODER EINER PHOTOMASKE MIT PELLICLE GEGENÜBER EINEM REINIGUNGSMEDIUM, VERFAHREN ZUM REINIGEN EINER PHOTOMASKE ODER EINER PHOTOMASKE MIT PELLICLE UND VORRICHTUNG ZUM ÖFFNEN UND SCHLIESSEN EINES HALTERS**
HOLDER FOR HOLDING AND FOR PROTECTING A SIDE OF A PHOTOMASK OR A PHOTOMASK HAVING PELLICLE FROM A CLEANING MEDIUM, METHOD FOR CLEANING A PHOTOMASK OR A PHOTOMASK WITH PELLICLE AND DEVICE FOR OPENING AND CLOSING A HOLDER
SUPPORT POUR RECEVOIR ET PROTÉGER UN CÔTÉ D'UN PHOTOMASQUE OU UN PHOTOMASQUE POURVU D'UNE PELLICULE CONTRE UN MILIEU DE NETTOYAGE, PROCÉDÉ DE NETTOYAGE D'UN PHOTOMASQUE OU D'UN PHOTOMASQUE POURVU D'UNE PELLICULE ET DISPOSITIF D'OUVERTURE ET DE FERMETURE D'UN SUPPORT

(30) Priorität: 16.11.2016 NL 2017806
(43) Veröffentlichungstag der Anmeldung: 25.09.2019
(73) Patentinhaber: Süss Microtec Photomask Equipment GmbH & Co. KG, 75447 Sternenfels (DE)
(72) Erfinder: KRÜMBERG, Jens, 75447 Sternenfels (DE); BESER, Adem, 75223 Niefern-Öschelbronn (DE); DIETZE, Uwe, 75447 Sternenfels (DE)
(74) Vertreter: Carstens, Dirk Wilhelm
(86) Internationale Anmeldenummer: PCT/EP2017/079497
(87) Internationale Veröffentlichungsnummer: WO 2018/091601

(56) Entgegenhaltungen:
- CN-A- 1 980 841
- JP-A- 2004 259 756
- JP-A- 2004 354 656
- US-A- 4 648 106

## Beschreibung

Die vorliegende Erfindung betrifft einen Halter zur Aufnahme und zum Schutz einer Seite einer Photomaske oder einer Photomaske mit Pellicle gegenüber einem Reinigungsmedium, ein Verfahren zum Reinigen einer Seite einer Photomaske oder einer Photomaske mit Pellicle sowie eine Vorrichtung zum Öffnen und Schließen eines Halters des zuvor genannten Typs.

Insbesondere im Gebiet der Halbleitertechnik ist es bekannt, Photomasken für photolithographische Prozesse einzusetzen. Zum Erreichen guter Prozeßergebnisse müssen diese Photomasken regelmäßig gereinigt werden, wobei zum Schutz bestimmter Oberflächen der Photomasken gegenüber Partikelverunreinigungen zum Teil sogenannte Pellicles eingesetzt werden. Pellicles sind dünne Filme oder Membranen, welche beispielsweise über einen Rahmen, der sie zu schützende Seite der Photomaske geklebt ist, beabstandet zur zu schützenden Oberfläche der Photomaske gehalten wird. Partikel können somit die entsprechende Oberfläche der Photomaske nicht erreichen, und setzen sich, sofern vorhanden, auf dem Pellicle ab. Das Pellicle ist dabei weit genug von der entsprechenden Maskenoberfläche entfernt, sodass zumindest Partikel unter einer bestimmten Größe, die sich auf dem Pellicle absetzen, ausreichend weit von der entsprechenden Oberfläche der Photomaske entfernt sind, dass sie Abbildungsprozesse nicht beeinträchtigen.

Somit können die Reinigungszyklen für die entsprechende Oberfläche wesentlich verringert werden. Jedoch ist es weiterhin notwendig, die dem Pellicle gegenüberliegende Seite zu reinigen. Während in der Vergangenheit in der Regel Pellicles mit ihrem Rahmen derart an der Seite der Photomaske befestigt waren, dass außerhalb des Rahmens ein umlaufender Randbereich der Maske frei blieb und als Dichtfläche dienen konnte, gehen heutige oder zukünftige Pellicles bis an den Rand der Photomaske heran, oder können sogar über diesen überstehen.

Während der Reinigung der dem Pellicle gegenüber liegenden Seite ist es erforderlich, die das Pellicle tragende Seite gegenüber dem eingesetzten Reinigungsmedium zu schützen. Hierdurch sollen Beschädigungen und/oder Verunreinigungen des Pellicles, seines Rahmen oder der das Pellicle tragenden Seite der Photomaske vermieden werden. Dies erfolgt bisher üblicherweise dadurch, dass der umlaufende Randbereich der das Pellicle tragende Seite auf einen Dichtrahmen aufgesetzt wurde. Dieser war so gestaltet, dass das Pellicle und die innerhalb des Randbereichs liegenden Seite der Maske gegenüber der Umgebung und insbesondere gegenüber einem Reinigungsmedium abgedichtet wurde. Bei Pellicles, die bis an den Randbereich der Photomaske heran gehen und/oder sogar darüber hinaus stehen, ist dies nun nicht mehr möglich, da kein ausreichender Oberflächenbereich der Photomaske auf der das Pellicle tragenden Seite zur Verfügung steht. Darüber hinaus kann es aber auch bei Photomasken ohne Pellicle vorteilhaft sein bei der Reinigung der einen Seite nicht die Andere zu kontaktieren. Aus der US 4 648 106 A ist ein Maskenhalter für ein Photomaske während einer Belichtung eines Substrats gezeigt. Der Maskenhalter ist geeignet die Photomaske mit einer Dichtung von oben her zu kontaktieren, um gemeinsam mit einer Kammer einen abgedichteten Belichtungsraum zu schaffen, in dem eine gezielte Gasatmosphäre einstellbar ist.

Daher ergibt sich nunmehr das Erfordernis, eine alternative Vorrichtung und ein Verfahren vorzusehen, welche geeignet sind, eine Seite einer Photomaske, insbesondere eine Pellicle tragende Seite der Photomaske, gegenüber einem Reinigungsmedium zu schützen, während die andere Seite mit eben diesem Reinigungsmedium gereinigt wird.

Erfindungsgemäß ist hierfür ein Halter gemäß Anspruch 1, ein Verfahren gemäß Anspruch 9, sowie eine spezielle Vorrichtung zum Öffnen und Schließen eines Halters gemäß Anspruch 11 vorgesehen. Weitere Ausgestaltungen der Erfindung ergeben sich aus den Unteransprüchen.

Insbesondere ist ein Halter zur Aufnahme und zum Schutz einer Photomaske oder einer Photomaske mit Pellicle gegenüber einem Reinigungsmedium vorgesehen, wobei der Halter Folgendes aufweist: eine Basis mit wenigstens drei Auflageelementen die zur Aufnahme und zum Halten der Photomaske oder der Photomaske mit Pellicle beabstandet zu einem Boden der Basis angeordnet sind, einen Dichtrahmen, mit einer Oberseite und einer Unterseite, wobei die Unterseite auf die Basis aufsetzbar ist, und wobei der Dichtrahmen eine Mittelöffnung aufweist, die so bemessen ist, dass sie die Photomaske mit Abstand aufnehmen kann, ein umlaufendes, elastisches Dichtelement am Dichtrahmen, das sich vom Innenumfang der Mittelöffnung schräg zur Oberseite des Dichtrahmens geneigt in die Mittelöffnung hinein erstreckt, wobei das Dichtelement in einem unbelasteten Zustand einen Innenumfang besitzt, der kleiner ist als der Außenumfang der Photomaske und in einem belasteten Zustand eine in der Mittelöffnung aufgenommene Photomaske umlaufend am Seitenrand kontaktiert. Ein solcher Halter ist geeignet eine Photomaske oder auch eine Photomaske mit Pellicle mit einem nach unten weisenden Pellicle auf der Basis aufzunehmen um dann den Dichtrahmen von oben her aufzubringen und über die spezielle Dichtung eine Abdichtung am Seitenrand vorzusehen. Der Dichtrahmen kann in umgekehrter Richtung wieder abgenommen werden und kontaktiert zu keinem Zeitpunkt die zur Basis weisende Seite der Photomaske und/oder ein Pellicle an der Photomaske.

Vorzugsweise sind die Auflageelemente so angeordnet sind, dass sie die Photomaske ausschließlich in einem Kantenbereich, insbesondere in den Eckbereichen der Photomaske kontaktieren. Die Auflageelemente können eine oder auch zwei abgeschrägte Auflagefläche aufweisen.

Gemäß einer Ausführungsform erstreckt sich die Dichtung im unbelasteten Zustand gleichmäßig vom Innenumfang der Mittelöffnung in diese hinein, und zwar über einen Abstand von 2,5 bis 3,5 mm und bevorzugt über ungefähr 2,9 mm. Hier ist der Abstand in der Ebene des Ober- oder Unterteils gemessen. Ferner kann die Dichtung im unbelasteten Zustand so bemessen sein, dass sie die Randbereiche einer hierzu zentrierten Photomaske überlappt, und zwar um 0,4 bis 1 mm, vorzugsweise um 0,6 bis 0,8 mm. Der entsprechende Überstand der Dichtung in die Mittelöffnung hinein sieht ausreichendes Material für eine Verformung der Dichtung vor, wenn die Photomaske aufgenommen wird und ist andererseits nicht zu groß um die Dichtung instabil werden zu lassen, wenn während der Reinigung einer Photomaske Kräfte hierauf wirken. Der Überlapp stellt wiederum eine ausreichende Verformung der Dichtung und eine entsprechende Andrückkraft der Dichtung gegen den Seitenrand der Photomaske sicher.

Bevorzugt besitzt die Dichtung eine Dicke im Bereich von 1 und 3 mm, vorzugsweise im Bereich 1,5 bis 2,5 mm und eine Shore Härte A im Bereich von 25° bis 75°. Für chemikalienbeständige Dichtungen, die beispielsweise aus FFKM Perfluoriertem Kautschuk oder EPDM Ethylen-Propylen-Dien-Kautschuk bestehen, haben sich die obigen Maße als besonders geeignet gezeigt, um eine gute Abdichtung gegen den Seitenrand einer Photomaske sicherzustellen.

Im nicht eingebauten und unbelasteten Zustand kann die Dichtung eine im Wesentlichen flache Konfiguration aufweisen und kann somit einfach hergestellt werden. Zum Innenumfang hin kann die Dichtung aber auch einen sich verjüngenden Bereich aufweisen. Für eine gute Abdichtung gegen den Seitenrand einer rechteckigen Photomaske besitzt die Dichtung einen im Wesentlichen rechteckigen Innenumfang, wobei die Eckbereiche des Innenumfangs abgerundet sind und vorzugsweise einen Radius im Bereich von 2-4 mm, insbesondere von ungefähr 3 mm aufweisen.

Bei einer Ausführungsform weist die Dichtung einen im Wesentlichen rechteckigen Außenumfang auf, wobei an wenigstens zwei gegenüberliegenden Kantenbereichen jeweils eine Montagelasche vorgesehen sein kann. Bevorzugt ist das Dichtungsmaterial an den jeweiligen Anwendungsbereich angepasst, sodass die Dichtung gegenüber dem einzusetzenden Reinigungsmedium und/oder UV-Strahlung beständig ist.

Der Dichtrahmen kann ein Oberteil und ein Unterteil aufweisen, die lösbar aneinander befestigt sind, wobei die Dichtung zwischen Oberteil und Unterteil eingeklemmt ist. Hierdurch läßt sich die Dichtung gut am Dichtrahmen befestigen und ist in leichter Weise austauschbar. Insbesondere können das Oberteil und das Unterteil einen umlaufenden, zur Mittelöffnung geöffneten Aufnahmeraum für die Dichtung bilden, der sich zur Mittelöffnung hin verjüngt und der zur Mittelöffnung hin schräg zur Oberseite des Dichtrahmens hin geneigt ist. Durch einen solchen Aufnahmeraum kann die Dichtung sicher gehalten und in die schräg zur Oberseite geneigte Ausrichtung gebracht werden. Bevorzugt ist der Aufnahmeraum für die Dichtung im Mittel um ungefähr 29° zur Oberseite des Dichtrahmens hin geneigt. Bevorzugt besitzt der Aufnahmeraum an seinem zur Mittelöffnung weisenden Ende eine Höhe, die kleiner ist als die Dicke der Dichtung. Insbesondere besitzt das zur Mittelöffnung weisenden Ende der Aufnahmeöffnung eine Höhe, die um 10% bis 20% kleiner ist als die Dicke der Dichtung, um diese sicher zu halten und noch weiter vorzuspannen.

Für den Einsatz bei einer Nassreinigung weist der Dichtrahmen in einem Bereich oberhalb einer Anbringung der Dichtung eine sich radial zum Umfang des Dichtrahmens erweiternde Schräge auf. Zum sicheren Halt des Dichtrahmens auf der Basis während des Einsatzes kann die Basis eine Halteeinheit, insbesondere eine Unterdruckeinheit, zum lösbaren Halten des Dichtrahmens aufweisen. Bei einer Ausführungsform können die Basis und/oder der Dichtrahmen wenigstens eine zum jeweils anderen Element, d.h. dem Dichtrahmen oder der Basis weisende, umlaufende Dichtung aufweisen, um den Kontaktbereich zwischen den beiden Elementen abzudichten. Die Basis und der Dichtrahmen können komplementäre Führungselemente aufweisen, welche bei einem Aufsetzen des Dichtrahmens auf der Basis eine Ausrichtung der Beiden zueinander bewirken.

Das Verfahren zum Reinigen einer Seite einer Photomaske, insbesondere einer Photomaske mit Pellicle, weist die folgenden Schritte auf: Aufnehmen der Photomaske in einem Halter des oben beschriebenen Typs, wobei die Photomaske zunächst mit ihrer nicht zu reinigenden Seite zur Basis weisend auf den Auflageelementen abgelegt und anschließend der Dichtrahmen derart auf die Basis aufgesetzt wird, dass das elastische Dichtelement die Photomaske umlaufend am Seitenrand kontaktiert und abdichtet, wobei die zu reinigenden Seite der Photomaske frei liegt, Reinigen der zu reinigenden Seite der Photomaske mit wenigstens einem Reinigungsmedium, das auf die zu reinigende Seite aufgebracht wird, Abnehmen des Dichtrahmens von der Basis in der umgekehrten Richtung zum Aufsetzen, während die Photomaske gegen die Auflageelemente gedrückt wird, und Abheben der Photomaske von den Auflageelementen. Ein solches Verfahren ermöglicht eine Abdichtung am Seitenrand der Photomaske und kann somit für Photomasken mit und ohne Pellicle in gleicher Weise eingesetzt werden. Durch das Abnehmen des Dichtrahmens in umgekehrter Richtung zum Aufbringen ist die Dichtung zu jedem Zeitpunkt von der zu schützenden Seite der Photomaske oder eines hieran befestigten Pellicles entfernt und es kann hier zu keinen Beschädigungen oder Verunreinigungen durch die Dichtung kommen. Indem die Photomaske während des Abnehmens des Dichtrahmens gegen die Auflageelemente gedrückt wird, wird verhindert, dass sie durch das Abnehmen selbst abgehoben oder verschoben und ggf. beschädigt wird.

Um die zu schützende Seite der Photomaske auch gegenüber Kontakt zu schützen, wird die Photomaske bevorzugt so auf den Auflageelementen abgelegt, dass nur Kantenbereiche, insbesondere Eckbereiche der Photomaske die Auflageelemente kontaktieren.

Beim Aufsetzen des Dichtrahmens auf die Basis wird das Dichtelement bevorzugt zur Oberseite des Dichtrahmens hin verformt, sodass sich die Unterseite des Dichtelements gegen den Seitenrand der Photomaske legt und gegen diesen abdichtet. Hierdurch kann eine gute Dichtwirkung erreicht werden.

Gemäß einer Ausführungsform ist das Reinigungsmedium ein flüssiges Medium und die gereinigte Seite der Photomaske wird vor dem Abnehmen des Dichtrahmens von der Basis getrocknet. Eine entsprechende Trocknung kann beispielsweise durch eine schnelle Rotation des Halters unterstützt werden. Eine Vorrichtung zum Öffnen und Schließen des oben beschriebenen Halters weist Folgendes auf: wenigstens zwei beabstandete, zueinander weisende Greifer, die zwischen einer geöffneten Position, in der sie den Dichtrahmen frei dazwischen aufnehmen können und einer geschlossenen Position, in der sie den Dichtrahmen greifen können bewegbar sind, eine Masken-Rückhalteeinheit mit wenigstens einem Rückhaltestift, der räumlich derart zwischen den Greifern liegt, dass er mit der Mittelöffnung im Dichtrahmen ausgerichtet ist, wenn dieser zwischen den Greifern aufgenommen ist und der sich im Wesentlichen senkrecht zu einer Öffnungs-/Schließbewegungsrichtung der Greifer erstreckt, wobei der wenigstens eine Rückhaltestift in seiner Erstreckungsrichtung bewegbar gehalten ist, eine Bewegungseinheit, die sowohl mit den Greifern als auch der Rückhalteeinheit gekoppelt ist, um diese gemeinsam zu bewegen. Eine solche Vorrichtung ist besonders geeignet beim Öffnen des Halters den Dichtrahmen von der Basis abzunehmen und eine darin aufgenommene Photomaske gegen Auflageelemente des Halters zu drücken, um sicherzustellen, dass beim Abnehmen nur der Dichtrahmen und nicht auch die Photomaske bewegt wird.

Bevorzugt ist der wenigstens eine Rückhaltestift in einem Führungselement aufgenommen und über ein Vorspanneinheit elastisch aus diesem heraus vorgespannt, wobei die Bewegung aus dem Führungselement heraus durch wenigstens einen Anschlag begrenzt ist. Eine entsprechende Halterung und Vorspannung kann eine vorbestimmte Kraft gegen die Photomaske vorsehen, wenn der Dichtrahmen abgenommen wird. Alternativ oder auch zusätzlich kann der wenigstens eine Rückhaltestift auch über einen steuerbaren Bewegungsmechanismus in seiner Erstreckungsrichtung bewegbar sein.

Bei einer Ausführungsform ist der wenigstens eine Rückhaltestift aus seiner Position zwischen den Greifern in eine neutrale Position bewegbar, in der er keine Rückhaltefunktion erfüllt. In dieser Position des wenigstens einen Rückhaltestifts kann die Vorrichtung ggf. auch zum Transport anderer Gegenstände wie zum Beispiel der Photomaske selbst eingesetzt werden. Gemäß einer Ausführungsform weist die Bewegungseinheit zwei beabstandete Arme auf, die jeweils wenigstens einen der Greifer tragen und sich wenigstens im Bereich der Greifer im Wesentlichen parallel in einer Längsrichtung erstrecken. Bevorzugt weist der Greifer an wenigstens einem der Arme einen Greifbackenhalter mit einer Greifbacke auf, wobei der Greifbackenhalter drehbar um eine sich in Längsrichtung des entsprechenden Arms erstreckende erste Drehachse gelagert ist und wobei die Greifbacke drehbar um eine sich senkrecht zur Längsrichtung des entsprechenden Arms erstreckende zweite Drehachse am entsprechenden Greifbackenhalter gelagert ist. Hierdurch kann der Greifer sich an einen nicht ordnungsgemäß ausgerichteten Dichtrahmen des Halters anpassen. Insbesondere können die erste und zweite Drehachse im Wesentlichen senkrecht zueinander angeordnet sein. Der Greifer an wenigstens einem der Arme kann einen Greifbackenhalter mit zwei in Längsrichtung des den Greifbackenhalter tragenden Arms beabstandete Greifbacken aufweisen, wobei die Greifbacken in einer Grundstellung des Greifbackenhalters auf einer Linie im Wesentlichen parallel zum Arm ausgerichtet sind und wobei der Greifbackenhalter um eine sich senkrecht zur Längsrichtung des entsprechenden Arms erstreckende dritte Drehachse gelagert ist. Dabei kann die dritte Drehachse zu dem anderen Arm hin weisen. Bevorzugt ist eine Vorspanneinheit vorgesehen, welche den Greifbackenhalter in die Grundstellung vorspannt.

Die Erfindung wird nachfolgend unter Bezugnahme auf die Zeichnungen näher erläutert. In den Zeichnungen zeigt:
- Fig. 1: eine schematische Draufsicht auf einen Halter ohne Dichtung gemäß der vorliegenden Erfindung;
- Fig. 2: eine schematische Schnittansicht durch den Halter entlang der Linie II-II in Fig. 1;
- Fig. 3: eine schematische Schnittansicht durch den Halter ähnlich Fig. 2, jedoch mit eingebauter Dichtung;
- Fig. 4: eine schematische perspektivische Ansicht einer Basis des Halters gemäß Fig. 1;
- Fig. 5: eine schematische, perspektivische Ansicht von oben auf ein Unterteil eines Dichtrahmens des Halters gemäß Fig. 1;
- Fig. 6: eine schematische, perspektivische Ansicht von unten auf ein Oberteil des Dichtrahmens des Halters gemäß Fig. 1;
- Fig. 7: eine schematische, perspektivische Ansicht von oben auf den Dichtrahmen des Halters gemäß Fig. 1;
- Fig. 8: eine vergrößerte, schematische Darstellung eines Klemmbereichs zwischen Oberteil und Unterteil des Dichtrahmens mit eingesetzter Dichtung;
- Fig. 9: eine vergrößerte, schematische Darstellung eines Klemmbereichs ähnlich Fig. 8 mit angedeuteter Photomaske in einem nicht aufgenommenen Zustand;
- Fig. 10: eine vergrößerte, schematische Darstellung ähnlich Fig. 9 mit angedeuteter Photomaske in einem aufgenommenen Zustand;
- Fig. 11: eine weitere schematische Detailansicht des Aufnahmebereichs einer Dichtung in einem Dichtrahmen;
- Fig. 12: eine Darstellung ähnlich Fig. 11, welche die Beziehung zu einer Photomaske darstellt;
- Fig. 13: eine Darstellung ähnlich Fig. 12 welche die Beziehung zu einer Photomaske mit Pellicle darstellt;
- Fig. 14: eine schematische Draufsicht auf eine beispielhafte Dichtung, die in den Halter gemäß Fig. 1 einsetzbar ist;
- Fig. 15: eine schematische Vorderansicht einer Vorrichtung zum Öffnen und Schließen eines Halters gemäß Fig. 1;
- Fig. 16: eine schematische Vorderansicht der Vorrichtung gemäß Fig. 15 wobei Rückhalteanordnungen der Vorrichtung in einer anderen Position als in Fig. 15 gezeigt sind;
- Fig. 17: eine schematische Seitenansicht von rechts gemäß Fig. 15, wobei die Figuren 17a und 17b unterschiedliche Positionen eines Greifbackenhalters zeigen;
- Fig. 18: eine schematische Seitenansicht ähnlich Fig. 17, wobei jedoch der in Fig. 17 gezeigte Greifbackenhalter weggelassen wurde;
- Fig. 19: vergrößerte, schematische Vorderansichten eines Teilbereichs der Vorrichtung gemäß Fig. 1, wobei Fig. 19a und 19b verschiedene Positionen eines Greifbackenhalters und eines entsprechenden Greifers zeigen.

In der nachfolgenden Beschreibung verwendete Richtungsangaben wie zum Beispiel oben, unten, links, rechts, horizontal, vertikal sowie Ableitungen derselben beziehen sich auf die Darstellungen in den Figuren und sind in keiner Weise einschränkend zu sehen, obwohl es sich auch um bevorzugte Anordnungen handeln kann.

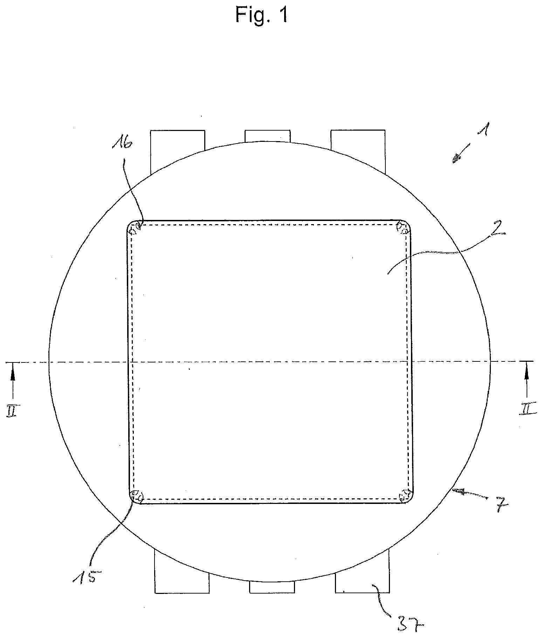

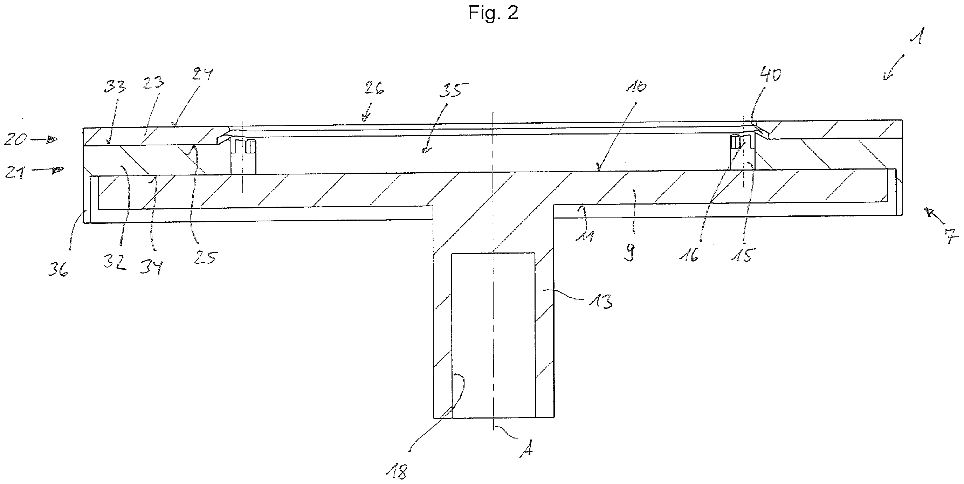

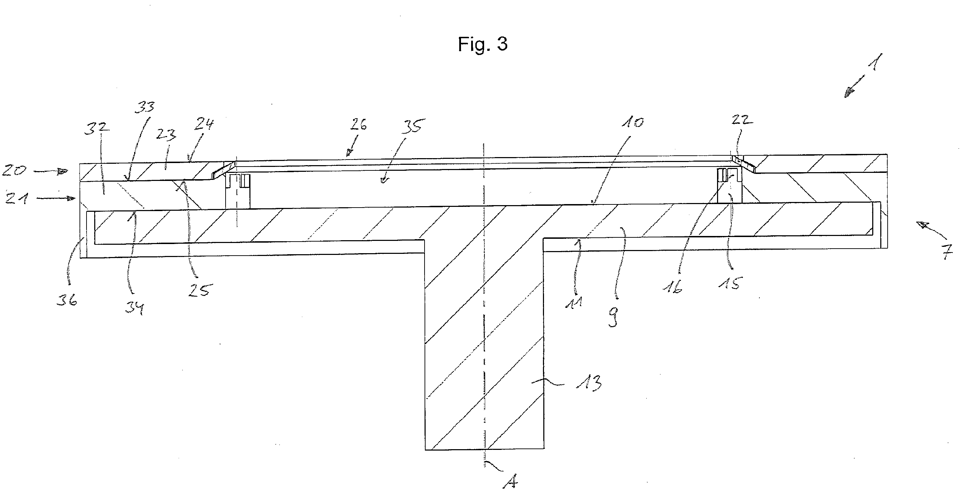

Fig. 1 zeigt eine schematische Draufsicht auf einen Halter 1 zur Aufnahme und zum Schutz einer Seite einer Photomaske 2 oder einer Photomaske mit Pellicle gegenüber einem Reinigungsmedium während einer Reinigung der anderen d.h. der nicht zu schützenden Seite der Photomaske 2. Die Photomaske 2 ist in Fig. 1 nur gestrichelt dargestellt und kann wie beschrieben eine Photomaske ohne Pellicle oder eine Photomaske mit Pellicle sein. In der Darstellung gemäß Fig. 1 ist zu Vereinfachung der Darstellung keine Dichtung dargestellt. Fig. 2 zeigt eine schematische Schnittansicht durch den Halter 1 gemäß Fig. 1 und Fig. 3 zeigt eine entsprechende Schnittansicht gemäß Fig. 2 mit eingesetzter Dichtung. Sofern im Nachfolgenden der Begriff Photomaske benutzt wird, soll dies in der Regel den Grundkörper der Photomaske betreffen, und zwar unabhängig davon, ob die Photomaske eine solch mit oder ohne Pellicle ist.

Der Halter 1 besteht aus einer Basis 5 und einem auf die Basis 5 aufsetzbaren Dichtrahmen 7. An der Basis 5 und/oder dem Dichtrahmen 7 kann eine Halteeinheit vorgesehen sein, um die beiden Elemente, wenn sie aufeinander sitzen lösbar zusammen zu halten. Insbesondere kann eine Unterdruckeinheit vorgesehen sein, die über entsprechende (nicht dargestellte Öffnungen) in der Basis 5 auf eine Unterseite des Dichtrahmens wirkt, um diesen auf der Basis zu halten. Es können aber auch andere Halteeinheiten vorgesehen werden, um die beiden Elemente lösbar aneinander zu halten.

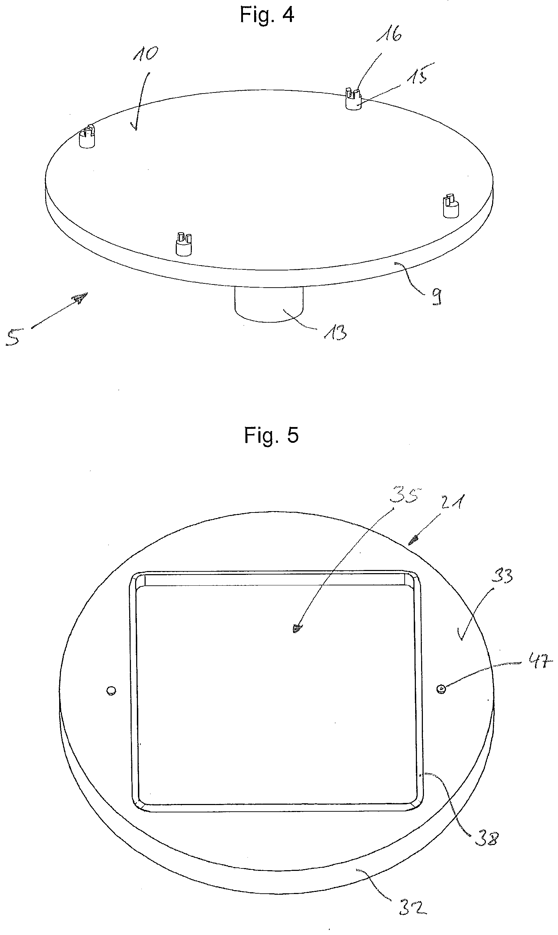

Die Basis 5 besteht im Wesentlichen aus einem kreisförmigen Plattenteil 9 mit einer Oberseite 10 und einer Unterseite 11 sowie einem Schaftteil 13 das sich senkrecht von der Unterseite 11 des Plattenteils 9 weg erstreckt. Die Oberseite 10 und die Unterseite 11 des Plattenteils 9 sind im Wesentlichen plan ausgebildet. Wie am besten in der schematischen, perspektivischen Ansicht gemäß Fig. 4 zu erkennen ist, sind auf der Oberseite 10 des Plattenteils 9 vier Auflageelemente 15 angebracht. Die vier Auflageelemente 15 sind derart angeordnet, dass sie eine rechteckige, insbesondere einer quadratische Photomaske 2 an ihren vier Eckbereichen aufnehmen können. Die Auflageelemente weisen jeweils zwei getrennte Auflagen 16 auf, die geeignet sind im Bereich der jeweiligen Ecken der Photomaske 2 diese an zwei unterschiedlichen Längskanten zu kontaktieren.

Obwohl in der Darstellung vier Auflageelemente 15 mit der speziellen Konfiguration von jeweils zwei Auflagen dargestellt sind, wird der Fachmann erkennen, dass auch eine geringere Anzahl von Auflageelementen, insbesondere drei Auflageelemente ausreichen würden, um eine Auflageebene aufzuspannen, die auch jeweils nur eine Auflage haben können. Die Auflageelemente 15 sind derart bemessen und angeordnet, dass sie eine darauf aufgenommene Photomaske 2 im Wesentlichen parallel über der Oberseite 10 anordnen. Bei einer Photomaske mit Pellicle besitzen die Auflageelemente 15 eine ausreichende Höhe, dass eine Photomaske mit nach unten weisenden Pellicle auf den Auflageelementen 15 derart aufgenommen werden kann, dass das Pellicle beabstandet über der Oberseite 10 der Basis 5 gehalten wird. Ferner sind die Auflageelemente 15 so angeordnet, dass sie wenn eine Photomaske 2 mit dem Pellicle nach unten weisend auf die Auflageelemente 15 aufgelegt wird, die Auflageelemente 15 das Pellicle und dessen Rahmen nicht kontaktieren. Insbesondere sind die Auflageelemente 15 so konfiguriert, dass sie die Photomaske nur an ihren nach unten weisenden Kanten kontaktieren. Hierzu weisen die Auflagen 16 jeweils abgeschrägte Oberseiten auf.

Der Schaftteil 13 ist bezüglich des Plattenteils 9 zentriert angeordnet und ist im Wesentlichen rund. Wie bei der Darstellung in Fig. 2 zu erkennen ist, kann der Schaftteil 13 wenigstens teilweise hohl sein und einen Aufnahmeraum 18 für die Welle eines Drehantriebs (nicht dargestellt) aufweisen. Alternativ kann der Schaftteil 13 aber auch massiv ausgebildet sein, wie in Fig. 3 angedeutet ist, und andere geeignete Strukturen zur Verbindung mit der Welle eines Drehantriebs aufweisen. Im Einsatz wird die Basis 5 üblicherweise über eine entsprechende Welle eines Drehantriebs drehbar gehalten, wobei die in den Figuren 2 und 3 eingezeichnete Achse A eine Drehachse darstellt.

Der Dichtrahmen 7 des Halters 1 besteht im Wesentlichen aus einem Oberteil 20, einem Unterteil 21 und einer Dichtung 22. Die Dichtung ist zur Vereinfachung in den Figuren 1 und 2 nicht dargestellt, jedoch in der Fig. 3 erkennbar. Zur Bildung des Dichtrahmens 7 sind dass Oberteil 20 und das Unterteil 21 über geeignete Befestigungselemente, wie beispielsweise Schrauben zerstörungsfrei lösbar derart miteinander verbunden, dass sie die Dichtung 22 dazwischen aufnehmen, wie nachfolgend näher erläutert wird.

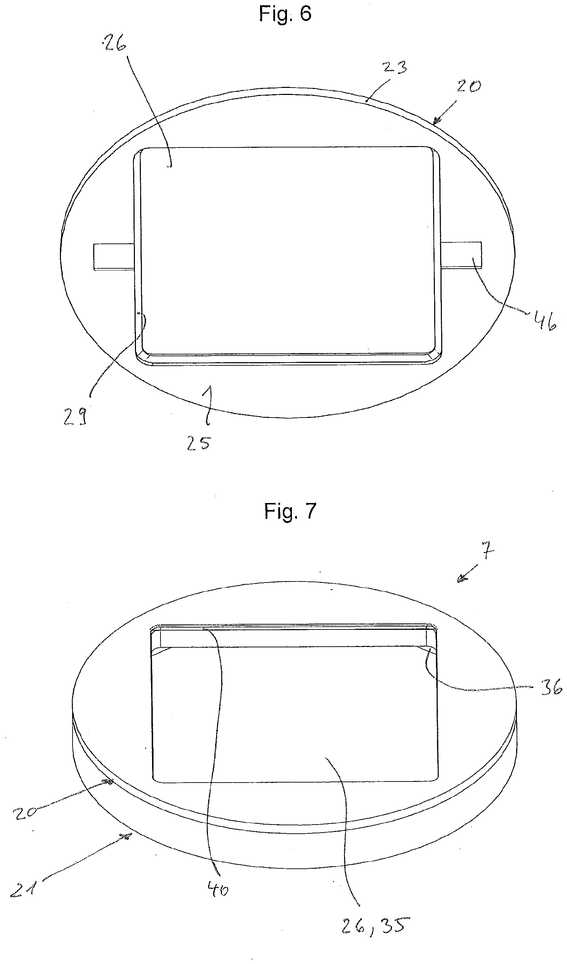

Das Oberteil 20 des Dichtrahmens ist allein perspektivisch von unten in Fig. 6 dargestellt und gemeinsam mit dem Unterteil 21 perspektivisch von oben in Fig. 7. Das Oberteil 20 besteht im Wesentlichen aus einem runden Plattenelement mit einer Oberseite 24, einer Unterseite 25 und einer Mittelöffnung 26, die sich zwischen Oberseite 24 und Unterseite 25 erstreckt.

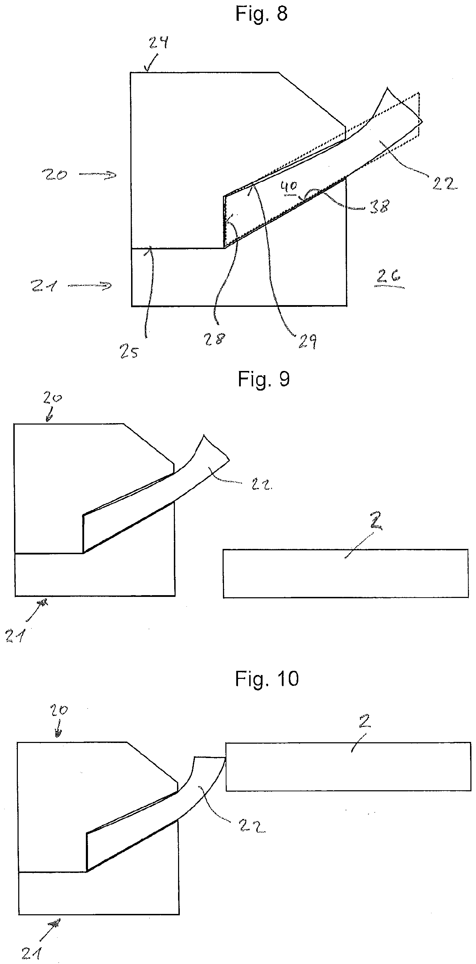

Die Oberseite 24 des Oberteils 20 ist im Wesentlichen plan ausgebildet, kann aber benachbart zur Mittelöffnung eine zur Unterseite geneigte Schräge, wie in den Figuren 8 bis 10 gezeigt oder auch eine Rundung aufweisen.

Auch die Unterseite 25 kann im Wesentlichen plan ausgebildet sein, jedoch können an der Unterseite Führungsstrukturen vorgesehen sein, welche eine Ausrichtung zum Unterteils 21 ermöglichen, wenn das Oberteil 20 und das Unterteil 21 zusammengefügt werden. Darüber hinaus können in der Unterseite 25 des Oberteils 20 eine Vielzahl von Sackbohrungen mit Gewinde vorgesehen sein, welche es zum Beispiel ermöglichen, dass das Oberteil 20 und das Unterteil 21 über geeignete Schrauben aneinander befestigt werden können. Es sind aber auch andere Befestigungsmöglichkeiten zwischen Oberteil 20 und 21 denkbar, die ein zerstörungsfreies lösen der beiden Elemente ermöglichen.

Im Bereich der Mittelöffnung 26 ist die Unterseite 25 des Oberteils 20 ferner konturiert, und zwar derart, dass zunächst eine sich senkrecht zur Unterseite 25 erstreckende Schulter 28 gebildet wird, die sich in Richtung der Oberseite 24 erstreckt. Diese Schulter 28 ist insbesondere in der vereinfachten Darstellung der Figur 8 zu erkennen, die eine vergrößerte, schematische Darstellung eines Dichtungs-Klemmbereichs zwischen Oberteil 20 und Unterteil 21 des Dichtrahmens 7 mit eingesetzter Dichtung zeigt. Diese Schulter 28 geht dann in eine Schräge 29 über, die sich von einer oberen Kante der Schulter 28 in Richtung der Mittelöffnung 26 erstreckt, und zwar zur Oberseite 26 hin geneigt. Insbesondere kann die Fläche 29 um ungefähr 25 bis 32 Grad bezüglich der Oberseite 24 geneigt sein und hat beispielsweise eine Neigung von ungefähr 28,5 Grad zur Oberseite 25 der Oberteils 20.

Die Mittelöffnung 26 weist eine rechteckige, insbesondere quadratische Form mit abgerundeten Eckbereichen auf und ist so bemessen, dass sie eine Photomaske 2 mit Abstand aufnehmen kann.

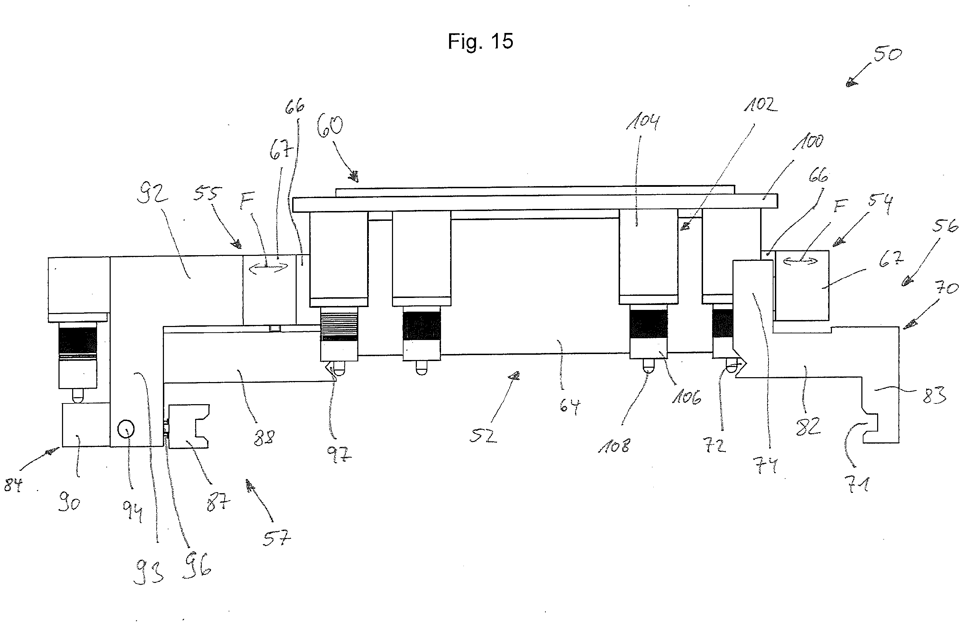

Das Unterteil 21 besteht wiederum im Wesentlichen aus einem Plattenelement 32 mit einer Oberseite 33, einer Unterseite 34, einer Mittelöffnung 35 und einem äußeren, umlaufenden Saum 36. Eine schematische, perspektivische Ansicht von oben auf das Unterteil 21 ist in Fig. 5 gezeigt. Das Plattenelement 32 des Unterteils 21 besitzt im Wesentlichen die gleichen Umfangsabmessungen wie das Plattenelement 23 des Oberteils 20. Die Mittelöffnung 35 im Unterteil 21 ist im Wesentlichen von der gleichen Form und Größe wie die Mittelöffnung 26 im Oberteil 20. Wenn das Oberteil 20 und das Unterteil 21 aneinander befestigt sind, sind die Mittelöffnungen 26, 35 zueinander ausgerichtet. Obwohl dies in den Figuren 5 und 7 nicht dargestellt ist, können am Außenumfang des Unterteils 21 Griffelemente 37 angebracht oder auch einteilig hiermit ausgebildet sein. Die Griffelemente 37, die mit einem entsprechenden Greifer zusammenarbeiten können, wie nachfolgend noch erläutert wird, sind nur in der Draufsicht gemäß Fig. 1 erkennbar. Statt der Griffelemente 37 am Unterteil 21 oder zusätzlich könnten Griffelemente 37 auch am Oberteil 20 des Dichtrahmens 7 ausgebildet sein. Wie in der Draufsicht zu erkennen ist, sind insgesamt sechs Griffelemente 37 vorgesehen, und zwar aufgeteilt in zwei Gruppen von je drei Griffelementen 37, die an gegenüberliegenden Seiten des Dichtrahmens angeordnet sind und zwar symmetrisch bezüglich zur Schnittebene II-II in Fig. 1. Wie der Fachmann erkennen wird, kann auch eine andere Anordnung von Griffelementen 37 statt der dargestellten vorgesehen werden. Zur Zusammenarbeit mit einer Vorrichtung zum Öffnen und Schließen des Halters, wie sie nachfolgend unter Bezugnahme auf die Figuren 15 bis 18 noch näher beschrieben wird, wären zum Beispiel drei der dargestellten Griffelemente 37 ausreichend, und zwar die äußeren Griffelemente 37 auf der einen Seite in Kombination mit dem mittleren Griffelement 37 auf der anderen Seite. Durch die Anordnung der sechs Griffelemente ist es möglich den Dichtrahmen auch mit einer 180° Verdrehung aufzunehmen.

Die Oberseite 33 und die Unterseite 34 des Plattenelements sind in weiten Bereichen plan ausgebildet, jedoch kann die Oberseite Führungsstrukturen aufweisen, um eine Ausrichtung zwischen Oberteil 20 und Unterteil 21 beim Zusammenfügen vorzusehen. Auch können in dem Plattenelement 32 nicht dargestellte Bohrungen ausgebildet sein, die mit entsprechenden Sackbohrungen im Oberteil 20 ausgerichtet werden können, um die beiden Elemente beispielsweise über Schrauben miteinander zu verbinden. Entsprechende Bohrungen und Verbinder sind in den Zeichnungen zur Vereinfachung der Darstellung jedoch nicht dargestellt.

Die Oberseite 33 besitzt benachbart zur Mittelöffnung 26 eine Erhöhung, die durch eine Schräge 38 gebildet wird. Die Schräge 38 erstreckt sich in Radialrichtung des Unterteils 21 über im Wesentlichen den gleichen Abstand wie die Schräge 29 im Plattenelement 23 des Oberteils 20. Die Schräge 38 ist bezüglich der planen Oberseite 33 des Plattenelements 32 beispielsweise zwischen 28 und 34 Grad geneigt und besitzt beispielsweise eine Schräge von ungefähr 30 Grad. Der Winkel zwischen den Schrägen 29 und 38 ist unterschiedlich, und insbesondere ist der Winkel der Schräge 38 um 1 bis 2 Grad steiler als der Winkel der Schräge 29. Hierdurch ergibt sich im zusammengebauten Zustand des Dichtrahmens 7 ein sich zur Mittelöffnung 26 hin verjüngender Aufnahmeraum 40 zwischen Oberteil 20 und Unterteil 21. Dieser sich verjüngende Aufnahmeraum 40 ist besonders gut in Fig. 8 zu erkennen, in der auch eine darin aufgenommene Dichtung 22 angedeutet ist. Die Funktion des sich verjüngenden Aufnahmeraums 40 wird nachfolgend näher erläutert, wenn die Dichtung 22 näher beschrieben wird.

In den jeweiligen abgerundeten Eckbereichen können die Schrägen 29 und 38 etwas steiler, beispielsweise um 0.5° steiler ausgebildet sein, um auch hier eine gute Vorspannung der Eckbereiche der Dichtung 22 nach oben vorzusehen. Hierdurch liegt die zur Mittelöffnung 26 weisende Öffnung der Aufnahmeraums 40 in den abgerundeten Eckbereichen leicht höher als in den anderen Bereichen.

Das Plattenelement 32 besitzt ferner einen äußeren, umlaufenden Saum 36, der sich im Wesentlichen senkrecht von der Unterseite 34 nach unten erstreckt, wie in Fig. 2 oder auch Fig. 3 zu erkennen ist. Wie in Fig. 2 zu erkennen ist, besitzt der Saum 36 Innenabmessungen, die zur vollständigen Aufnahme des Plattenteils 9 der Basis 5 geeignet ist, wenn der Dichtrahmen 7 auf der Basis 5 aufliegt. Obwohl dies nicht näher dargestellt ist, kann zwischen der Unterseite 34 des Unterteils 21 und der Oberseite des Plattenteils 9 wenigstens eine Dichtung vorgesehen sein, die an einem der beiden Elemente befestigt ist.

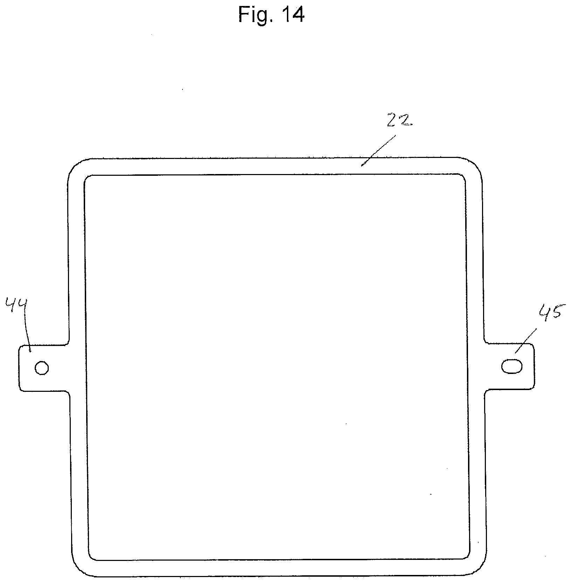

Die Dichtung 22, die erstmalig in Fig. 3 zu sehen ist, wird nachfolgend unter Bezugnahme auf die Figuren 3 und 8 bis 14 näher erläutert. Dabei zeigt die Fig. 14 eine Draufsicht auf eine beispielhafte Dichtung 22, während die Figuren 8 bis 13 schematisch und vergrößert eine Klemmung der Dichtung 22 zwischen Oberteil 20 und Unterteil 21 des Dichtrahmens sowie teilweise die Beziehung der Dichtung 22 zu einer Photomaske zeigen.

Wie in der Draufsicht gemäß Fig. 14 zu erkennen ist, besitzt die Dichtung 22 eine im Wesentlichen rechteckige, insbesondere eine im Wesentlichen quadratische Ringform mit abgerundeten Eckbereichen. An zwei gegenüber liegenden Längsseiten der Ringform sind nach außen weisende Befestigungslaschen 44, 45 vorgesehen.

Die Dichtung 22 besitzt in einem nicht eingebauten Zustand eine im Wesentlichen plane Konfiguration und besteht aus einem geeigneten Dichtungsmaterial, das gegenüber Reinigungsmedien, die bei der Reinigung einer Photomaske 2 eingesetzt werden, beständig ist. Als Materialien sind hier beispielsweise FFKM Perfluoriertem Kautschuk oder EPDM Ethylen-Propylen-Dien-Kautschuk geeignet. Die Dichtung 22 besitzt bevorzugt eine Dicke im Bereich von 1 bis 3 Millimeter, vorzugsweise im Bereich 1,5 bis 2,5 Millimeter, und weist eine Shore Härte A im Bereich von 25° bis 75° auf. Der im Wesentlichen rechteckige Innenumfang der Dichtung weist abgerundete Eckbereiche auf, wobei der Radius der Rundung vorzugsweise im Bereich von 2 bis 4 Millimeter insbesondere im Bereich von ungefähr 3 Millimeter liegt. Obwohl dies in den Figuren nicht dargestellt ist, kann die Dichtung einen sich zur Mittelöffnung hin verjüngenden Mittelbereich aufweisen.

Die Befestigungslaschen 44, 45 sind so bemessen, dass sie in entsprechende Aufnahmen in der Unterseite 25 des Plattenelements 23 des Oberteils 20 des Dichtrahmens 7 passen, die bei 46 in Fig. 6 gezeigt sind. Die Befestigungslaschen 44, 45 weisen jeweilige Befestigungsöffnungen auf, um die Dichtung 22 an dem Unterteil 21 des Dichtrahmens 7 in geeigneter Weise, beispielsweise über Stifte 47, die an der Oberseite 33 des Plattenelements 32 vorgesehen sind (siehe Fig. 5), befestigen zu können. Natürlich können auch zusätzliche Befestigungslaschen vorgesehen sein oder auch auf die Befestigungslaschen 44, 45 verzichtet werden.

Wie am Besten in Fig. 8 zu erkennen ist, besitzt die Dichtung 22 im Wesentlichen eine Dicke entsprechend der Höhe der Schulter 28 an der Unterseite 25 des Oberteils 20 des Dichtrahmens 7. Durch die Schräge 38 am Unterteil 21 des Dichtrahmens 7 wird die Dichtung in eine nach oben gerichtete Richtung geneigt, wie in Fig. 8 dargestellt ist. Dabei zeigt die gestrichelte Form der Dichtung 22 in Fig. 8 die Dichtung wie sie aussehen würde, wenn sie nur durch das Unterteil 21 gehalten werden würde, bzw. wenn der Aufnahmeraum 40 sich nicht verjüngen würde. Die durchgezogene Form nimmt die Dichtung 22 an, wenn das Oberteil 20 am Unterteil 21 befestigt ist. Durch den sich verjüngenden Aufnahmeraum 40 weist der Aufnahmeraum 40 benachbart zur Mittelöffnung 26 eine geringere Höhe auf, als die Dichtung 22 in einem unbelasteten Zustand hätte. Dadurch wird die Dichtung 22 in diesem Bereich gequetscht, was sie einerseits fixiert, und andererseits noch eine weitere Vorspannung nach oben erfahren lässt. Insbesondere ist die Höhe des Aufnahmeraums 40 an seinem zur Mittelöffnung 26 weisenden Ende um 10 % bis 20% geringer als die Dicke der Dichtung im unbelasteten Zustand.

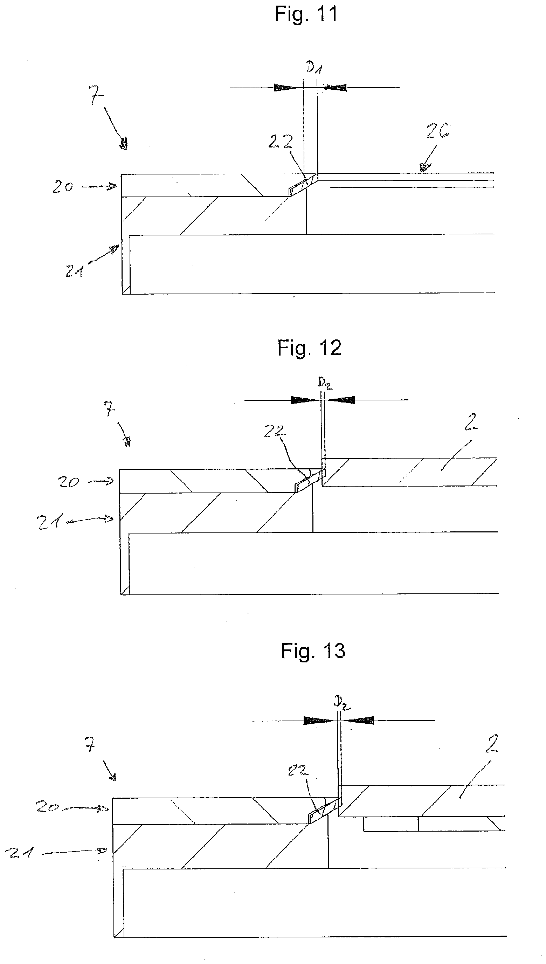

Die Dichtung 22 ist so bemessen, dass sie sich im eingebauten Zustand, d.h. wenn sie zwischen Oberteil 20 und Unterteil 21 aufgenommen ist, im Wesentlichen gleichmäßig vom Innenumfang der Mittelöffnung 26 in diese hinein erstreckt und zwar über einen Abstand D₁ von 2,5 mm bis 3,5 mm und bevorzugt von ungefähr 2,9 mm und zwar in Radialrichtung des Ober- oder Unterteils 20, 21, wie zum Beispiel in Fig. 11 dargestellt ist. Darüber hinaus ist die Dichtung 22 so bemessen, dass sie im unbelasteten Einbauzustand die Randbereiche einer hierzu zentrierten Photomaske über einen Abstand D₂ von etwa 0,4 bis 1 mm, vorzugsweise von 0,6 bis 0,8 mm in Radialrichtung überlappt, wie am Besten in den Figuren 13 und 14 dargestellt ist, und zwar unabhängig davon, ob die Photomaske 2 eine Photomaske ohne Pellicle oder eine solche mit Pellicle ist, wie in den Figuren 12 und 13 dargestellt ist.

Wenn eine Photomaske 2 in der Mittelöffnung 26 des Dichtrahmens 7 derart aufgenommen ist, dass die Photomaske die Dichtung 22 kontaktiert, wird diese daher noch weiter nach oben umgebogen, wie schematisch in Fig. 10 dargestellt ist. Die Dichtung 22 kontaktiert die Photomaske 2 dann am Umfangsrand und dichtet gegen diesen ab. Eine entsprechende Abdichtung wird durch die spezielle Formgebung der Dichtung 22, die sie durch das Einklemmen zwischen Oberteil und Unterteil 20, 21 des Dichtrahmens 7 erfährt, gefördert. Die Dichtwirkung erfolgt hier dann über eine Unterseite der Dichtung 22, wie in Fig. 10 dargestellt ist. Durch die schräge Anordnung der Dichtung 22 wird ein guter Kontakt der Unterseite der Dichtung 22 mit dem Umfangsrand der Photomaske 2 gefördert. Die schräge Anordnung ermöglicht aber auch, dass der Dichtrahmen 7 leicht von oben her auf die Photomaske 2 aufgesetzt und in umgekehrter Reihenfolge wieder abgehoben werden kann, wie nachfolgend noch näher beschrieben wird.

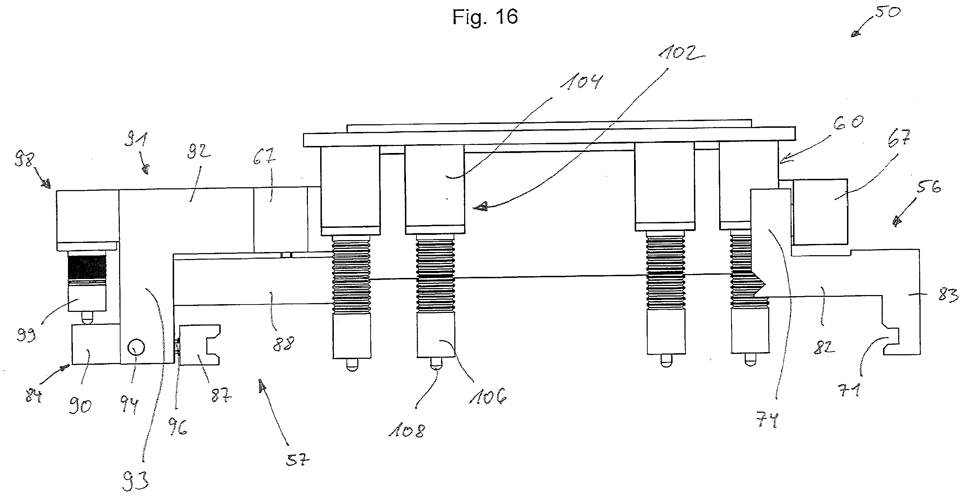

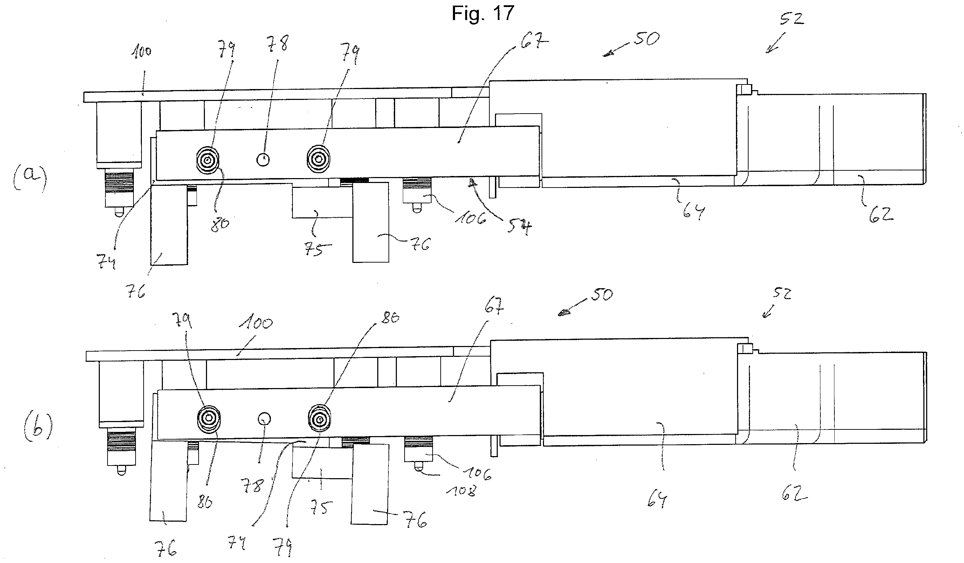

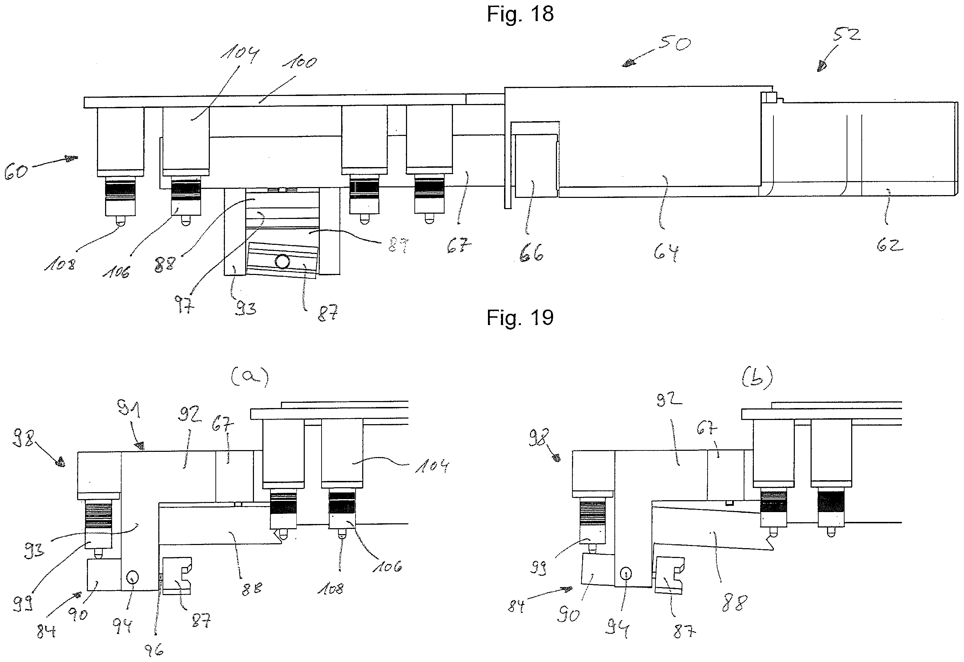

Anhand der Figuren 15 bis 19 wird nunmehr eine spezielle Vorrichtung 50 zum Öffnen und Schließen des zuvor beschriebenen Halters 1 näher erläutert. Dabei zeigt Fig. 15 eine schematische Vorderansicht der Vorrichtung 50, Fig. 16 eine schematische Seitenansicht von rechts gemäß Fig. 15, Fig. 17 eine schematische Seitenansicht ähnlich Fig. 16 wobei jedoch ein Teil der Vorrichtung weggelassen wurde, und Fig. 19a und 19b vergrößerte, schematische Vorderansichten eines Teilbereichs der Vorrichtung 50 mit einer Greifbacke der Vorrichtung in unterschiedlichen Positionen.

Die Vorrichtung 50 besteht im Wesentlichen aus einem Hauptarm 52, einem ersten Greiferarm 54, einem zweiten Greiferarm 55, einer ersten Greifanordnung 56 am ersten Greiferarm und eine zweite Greiferanordnung 57 am zweiten Greiferarm, sowie eine Masken-Rückhalteanordnung 60.

Der Hauptarm 52 besitzt ein erstes Anbringungsende 62 sowie ein zweites Anbringungsende 64. Das erste Anbringungsende 62 kann in irgendeiner geeigneten Art und Weise mit einem Bewegungsmechanismus verbunden sein, der geeignet ist den Hauptarm 52 dreidimensional im Raum zu bewegen. Entsprechende Bewegungsmechanismen sind in der Technik ausreichend bekannt und werden hier daher nicht näher erläutert.

Das zweite Anbringungsende 64 ist starr am ersten Anbringungsende 62 befestigt und trägt die ersten und zweiten Greiferarme 54, 55 sowie die Masken-Rückhalteanordnung 60.

Darüber hinaus ist in dem zweiten Anbringungsende ein nicht näher dargestellter Antrieb vorgesehen, der geeignet ist, die ersten und zweiten Greiferarme 54, 55 relativ zueinander zu bewegen, wie nachfolgend noch näher erläutert wird.

Die Greiferarme 54, 55 besitzen jeweils im Wesentlichen eine L-Form. Ein jeweiliger erste Schenkel 66 der L-Form, der nachfolgend auch als kurzer Schenkel 66 bezeichnet wird, ist in dem zweiten Anbringungsende 64 des Hauptarms 52 aufgenommen und in diesem in seiner Längsrichtung geführt. Insbesondere sind die jeweiligen kurzen Schenkel 66 derart in dem zweiten Anbringungsende 64 des Hauptarms 52 angeordnet, dass sie im Wesentlichen parallel zueinander liegen und sich aus gegenüberliegenden Seiten des zweiten Anbringungsendes 64 heraus erstrecken. Insbesondere können die kurzen Schenkel 66 der Greiferarme 54, 55 zueinander ausgerichtet sein und aufeinander zu und voneinander weg bewegbar gehalten werden.

Zweite Schenkel 67, die nachfolgend auch als lange Schenkel 67 bezeichnet werden erstrecken sich im rechten Winkel zu den kurzen Schenkeln 66 und zwar bezüglich des zweiten Anbringungsendes 64 nach vorne, sodass die langen Schenkel 67 der Greiferarme über ein Vorderende des Hauptarms 52 vorstehen. Mithin erstrecken sich beide Schenkel 66, 67 der jeweiligen Greiferarme 54, 55 horizontal. Die langen Schenkel 67 der Greiferarme 54, 55 erstrecken sich hierbei im Wesentlichen parallel zueinander.

Wie durch die Doppelpfeile F in Fig. 15 angedeutet ist, sind die langen Schenkel 67 über eine entsprechende Bewegung der kurzen Schenkel 66 aufeinander zu und voneinander weg bewegbar, um den Abstand dazwischen in geeigneter Weise zu ändern. Die Schenkel 66, 67 besitzen jeweils einen rechteckigen Querschnitt.

Der erste Greiferarm 54 trägt an seinem langen Schenkel 67 eine erste Greiferanordnung 56 während der zweite Greiferarm 55 an seinem langen Schenkel 67 eine zweite Greiferanordnung 57 trägt.

Die erste Greiferanordnung 56 besteht im Wesentlichen aus einer Greifbacke 70 mit zwei ersten Greifern 71 sowie wenigstens einem zweiten Greifer 72.

Die Greifbacke 70 weist einen Befestigungsschenkel 74, einen Verlängerungsschenkel 75, sowie zwei L-förmige Greiferteile 76 auf. Der Befestigungsschenkel 74 besitzt eine langgestreckte Form mit einem im Wesentlichen rechteckigen Querschnitt. Der Befestigungsschenkel 74 ist an dem langen Schenkel 67 des ersten Greiferarms 54 angebracht, und zwar an der zum zweiten Greiferarm 55 weisenden Seite des langen Schenkels 67. Insbesondere ist der Befestigungsschenkel 74 über eine Drehachse 78 drehbar an dem langen Schenkel 67 angebracht. Die Drehachse 78 erstrecke sich senkrecht zur Längserstreckung des langen Schenkels 67 in Richtung des zweiten Greiferarms 55.

Darüber hinaus sind an dem Befestigungsschenkel 74 beidseitig der Drehachse 78 zwei Führungsstifte 79 vorgesehen, die in sich beidseitig der Drehachse 78 erstreckenden Langlöchern des langen Schenkels 67 des ersten Greiferarms 54 aufgenommen sind. Hierdurch wird eine Verdrehung des Befestigungsschenkels 74 relativ zum langen Schenkel 67 des Greiferarms 54 begrenzt, wie beispielsweise in Fig. 16b dargestellt ist. Der Befestigungsschenkel 74 ist über geeignete Vorspannmittel, die beispielsweise innerhalb eines Langlochs 80 auf den Führungsstift 79 wirken oder auch andere geeignet angeordnete Vorspannmittel in einer Ausrichtung vorgespannt, in der die Längserstreckung des Befestigungsschenkel 74 im Wesentlichen parallel zur Längserstreckung des langen Schenkels 67 des ersten Greiferarms 54 ausgerichtet ist. Eine entsprechende Stellung ist beispielsweise in Fig. 16a zu erkennen.

Der Verlängerungsschenkel 75 schließt sich unten an dem näher zum Hauptarm 52 liegenden Ende des Befestigungsschenkels 74 an und erstreckt sich im Wesentlichen parallel hierzu in Richtung des Hauptarms 52. Am freien, d.h. vom Befestigungsschenkel 74 entfernten Ende des Verlängerungsschenkels 75 ist einer der L-förmigen Greiferteile 76 angebracht. Ein entsprechender L-förmiger Greiferteil 76 ist auch am Befestigungsschenkel 74 vorgesehen, und zwar an dem vom Hauptarm 52 entfernten Ende des Befestigungsschenkels 74. Der Befestigungsschenkel 74, der Verlängerungsschenkel 75 sowie die L-förmigen Greiferteile 76 können einteilig ausgebildet sein, können aber auch aus unterschiedlichen Elementen bestehen, die aneinander befestigt sind. Derzeitig wird jedoch eine einteilige Form bevorzugt.

Die L-förmigen Greiferteile 76 besitzen jeweils einen langgestreckten ersten Schenkel 82, der sich im Wesentlichen unter dem Befestigungsschenkel 74 senkrecht hierzu erstreckt, und zwar horizontal unterhalb des langen Schenkels 67 des ersten Greiferarms 54 hindurch. Am freien Ende des ersten Schenkels 82 erstreckt sich senkrecht hierzu nach unten ein zweiter Schenkel 83. Der ersten Schenkel 82 besitzt an seinem zum zweiten Greiferarm 55 weisenden Ende eine Kerbe auf, die zur Bildung des zweiten Greifers 72 dient.

In dem sich nach unten erstreckenden zweiten Schenkel 83 ist ebenfalls eine Kerbe ausgebildet, die einen der ersten Greifer 71 der Greifbacke 70 bildet. Da zwei der L-förmigen Greiferteile 76 vorgesehen sind, sind entsprechend auch zwei in Längsrichtung des Befestigungsschenkels 74 und somit in Längsrichtung des langen Schenkels 67 des ersten Greiferarms 54 beabstandete erste Greifer 71 vorgesehen. Die Greifer 71 und 72 sind durch Einkerbungen in den jeweiligen Schenkelteilen der Greiferbacke gebildet. Sie können aber auch auf andere Weise ausgebildet werden, insbesondere auch als separate Elemente an den jeweiligen Schenkelteilen der Greiferbacke angebracht sein.

Die zweite Greiferanordnung 57, die am zweiten Greiferarm 55 angebracht ist, wird im Wesentlichen durch eine Greiferbacke 84 und einem an der Greiferbacke 84 angebrachten ersten Greifer 87 sowie einem zweiten Greifer 97 gebildet. Die Greiferbacke 84 besitzt einen ersten horizontalen Schenkel 88 einen vertikalen Verbindungsschenkel 89 und einen zweiten horizontalen Schenkel 90. Die Greiferbacke 84 kann wiederum einteilig ausgebildet sein oder aus mehreren Einzelteilen bestehen.

Der erste horizontale Schenkel 88 erstreckt sich senkrecht unter dem langen Schenkel 67 des zweiten Greiferarms 55 hindurch. An der Unterseite des langen Schenkels 67 des zweiten Greiferarms 55 ist ein einstellbarer Anschlag vorgesehen, gegen den sich die Oberseite des ersten horizontalen Schenkels 88 abstützen kann, wie beispielsweise in der Ansicht gemäß Fig. 15 zu erkennen ist. An dem zum ersten Greiferarm 54 weisenden Ende des ersten Schenkels 88 ist der zweite Greifer 97 in Form einer Kerbe ausgebildet, und zwar in gleicher Weise wie der zweite Greifer 72 an der ersten Greiferbacke 70.

Am dem dem zweiten Greifer 97 entgegengesetzten Ende des ersten horizontalen Schenkels 88 befindet sich der vertikale Verbindungsschenkel 89, der sich von dem entsprechenden Ende senkrecht nach unten erstreckt. Am unteren Ende des vertikalen Verbindungsschenkels 89 befindet sich dann der zweite horizontale Schenkel 90, der sich wiederum senkrecht zum vertikalen Verbindungsschenkel 89 erstreckt.

Der zweite horizontale Schenkel 90 erstreckt sich im Wesentlichen parallel zum ersten horizontalen Schenkel 88. An seinem zum ersten Greiferarm 54 weisenden Ende des zweiten horizontalen Schenkels 90 trägt dieser den ersten Greifer 87. Der erste Greifer 87 ist um eine sich parallel zum zweiten horizontalen Schenkel 90 erstreckende Drehachse 96 drehbar gelagert. Die Drehachse 96 ist zum ersten Greiferarm 54 hin gerichtet.

Die Greiferbacke 84 ist über einen Befestigungsbügel 91 an dem zweiten Greiferarm 55 angebracht. Insbesondere ist der Befestigungsbügel 91 an einer vom ersten Befestigungsarm 54 weg weisenden Seite des langen Schenkels 67 des zweiten Befestigungsarms 55 angebracht. Eine entsprechende Anbringung kann in irgendeiner geeigneten Art und Weise erfolgen. Der Befestigungsbügel 91 besitzt im Wesentlichen eine abgewinkelte Form mit einem horizontalen Schenkel 92 und einem vertikalen Schenkel 93, der sich von einem Ende der horizontalen Schenkels 92 senkrecht nach unten erstreckt. An seinem unteren Ende trägt der vertikale Schenkel 93 des Befestigungsbügels 91 eine Drehachse 94. Die Drehachse 94 erstreckt sich im Wesentlichen parallel zu dem langen Schenkel 67 des zweiten Befestigungsarms 55in einer horizontalen Ausrichtung.

Der zweite horizontalen Schenkel 90 der Greiferbacke 84 ist über die Drehachse 94 drehbar an dem Befestigungsbügel 92 angebracht. An dem Befestigungsbügel 91 ist Ferner eine Vorspanneinheit 98 mit einem in geeigneter Weise nach unten vorgespannten Stift 99 vorgesehen, welche auf ein Ende des zweiten horizontalen Schenkels 90 wirkt. Der Stift 99 drückt derart auf den zweiten horizontalen Schenkel 90, dass er sich entgegen dem Uhrzeigersinn gemäß Fig. 15 um die Drehachse dreht. Diese Drehung wird dadurch begrenzt, dass der Anschlag am ersten horizontalen Schenkel 88 mit der Unterseite am langen Schenkel 67 des zweiten Befestigungsarms 55 in Kontakt kommt. In dieser Stellung sind der erste horizontale Schenkel 88 und der zweite horizontale Schenkel 90 der Greiferbacke 84 horizontal ausgerichtet. Wie in Fig. 19b angedeutet ist, kann die Greiferbacke jedoch auch gegen die Vorspannung des Stifts 99 im Uhrzeigersinn um die Drehachse 94 gedreht werden.

Die ersten und zweiten Greiferanordnungen 56 und 57 sind derart an den jeweiligen ersten und zweiten Greiferarmen 54, 55 angeordnet, dass in einer Ruhestellung der Greiferanordnungen die Greifer 71 und 87 in einer horizontalen Ebene liegen und zueinander weisen. In gleicher Weise liegen die Greifer 72 und 97 in einer Ruhestellung der Greiferanordnungen in einer horizontalen Ebene und weisen zueinander.

Durch die bewegliche Anordnung der ersten und zweiten Greiferbacken 70, 84 relativ zu den jeweiligen Greiferarmen 54, 55 sowie die zusätzliche Drehbarkeit des Greifers 87 ist eine Anpassung der entsprechenden Greifer 87, 71 an nicht horizontal ausgerichtete Elemente möglich. Insbesondere sind die Greifer 87, 71 zum Greifen der Griffelemente 37 eines Dichtrahmens 7 eines zuvor beschriebenen Halters 1 konfiguriert. Die Greifer 72, 97 können hingegen für das Greifen anderer Elemente, wie zum Beispiel einer Photomaske eingesetzt werden.

Die Masken-Rückhalteanordnung 60 der Vorrichtung 50 besteht im Wesentlichen aus einem sich horizontal erstreckenden Plattenelement 100, sowie daran angebrachten Rückhalteanordnungen 102.

Das Plattenelement 100 ist an einem Ende an dem zweiten Anbringungsende 64 des Hauptarms 52 befestigt, und zwar derart, dass es sich parallel zu den Greiferarmen 54, 55 erstreckt. Das Plattenelement 100 kann starr an dem Anbringungsende 64 des Hauptarms 52 angebracht sein, kann aber auch höhenverstellbar daran gehalten werden und/oder schwenkbar, wobei das Plattenelement 100 in seiner in den Figuren dargestellten Position arretiert werden kann.

Die Rückhalteanordnungen 102 bestehen jeweils aus Aufnahmebuchsen 104 sowie Rückhaltestiften 106, die beweglich in den Aufnahmebuchsen 104 angeordnet sind. Insbesondere sind vier dieser Rückhalteanordnungen 102 an einer Unterseite des Plattenelements 100 angeordnet. Hierzu sind jeweils die Aufnahmebuchsen 104 in einer geeigneten Art und Weise an der Unterseite des Plattenelements 100 befestigt, und zwar derart, dass sich eine Längsachse der jeweiligen Aufnahmebuchsen 104 senkrecht zum Plattenelement 100 erstreckt.

Innerhalb der Aufnahmebuchsen 104 wird ein jeweiliger Aufnahmeraum (nicht gezeigt) für die Rückhaltestifte 106 gebildet, in dem die Rückhaltestifte 106 in Längsrichtung verschiebbar geführt sind. Innerhalb dieses Aufnahmeraums der Aufnahmebuchsen 104 ist jeweils auch eine Vorspanneinheit (nicht gezeigt) vorgesehen, welche die Rückhaltestifte 106 aus den Aufnahmebuchsen 104 heraus vorspannt. Dabei ist eine Bewegung der Rückhaltestifte 106 aus den Aufnahmebuchsen 104 heraus in geeigneter Weise begrenzt. Eine entsprechende Vorspanneinheit kann beispielsweise durch mechanische Federn, pneumatische Federn oder sonstige Elemente gebildet werden. Während Fig. 15 eine vollständige eingefahrene Position der Rückhaltestifte 106 zeigt, zeigt Fig. 16 eine vollständig ausgefahrene Position der Rückhaltestifte 106.

Die Rückhaltestifte 106 weisen jeweils einen nicht dargestellten Führungsteil auf, der innerhalb der Aufnahmebuchse 104 aufgenommen ist, sowie einen sich hieraus erstreckenden Teil, der am unteren Ende eine Kontaktspitze 108 trägt. Die Rückhaltestifte 106 sind gegen die Vorspannkraft der Vorspanneinheiten in die Aufnahmebuchse 104 hinein bewegbar und aus diesen heraus, wie der Fachmann erkennen wird. In gleicher Weise können auch die Kontaktspitzen 108 federnd innerhalb der Rückhaltestifte 106 gelagert sein. Der Außerhalb der Aufnahmebuchse 104 liegende Teil der jeweiligen Rückhaltestifte 106 ist in einer Ummantelung aufgenommen, die an den jeweiligen Aufnahmebuchse 104 befestigt ist. Die Ummantelung bildet eine Art Balgen, sodass gegebenenfalls durch die Führung der Rückhaltestifte 106 in den Aufnahmebuchsen entstehende Partikel eingeschossen sind und nicht auf eine darunter liegende Photomaske fallen können.

In einer Arbeitsstellung der Masken-Rückhalteanordnung 60, wie sie beispielsweise in Fig. 16 dargestellt ist, befindet sich das Plattenelement 100 in einer Position, wie dargestellt. Hierdurch werden die Rückhaltestifte 106 derart zischen den Greiferarmen 54, 55 positioniert, dass dann, wenn die Greifer 87, 71 Griffelemente 37 an einem Dichtrahmen 7 ergreifen, in dem keine Photomaske aufgenommen ist, sich wenigstens die Kontaktspitzen 108 der Rückhaltestifte 106 in die Mittelöffnung 26 des Dichtrahmens 7 hinein erstrecken. Wenn hingegen eine Photomaske innerhalb des Dichtrahmens 7 aufgenommen ist, würden die Kontaktspitzen 108 die Oberseite der Photomaske 2 kontaktieren und die Rückhaltestifte 106 würden in die Aufnahmebuchsen 104 einfedern.

Nachfolgend wird nunmehr ein Reinigungsvorgang unter Verwendung des zuvor beschriebenen Halters 1 und der Vorrichtung 50 zum Öffnen und Schließen des Halters näher erläutert. Zunächst wird eine Photomaske 2 mit einer zu schützenden Seite bzw. mit einem Pellicle nach unten weisend auf den Auflagen 16 der Auflageelemente 15 abgelegt. Anschließend wird der Dichtrahmen 7 von oben her durch die Vorrichtung 50 über der Basis 5 platziert und in Richtung derselben bewegt. Dabei kommen die Kontaktspitzen der Rückhaltestifte 106 mit der nach oben weisenden Seite der Photomaske 2 in Kontakt und drücken die Photomaske gegen die Auflagen 16. Bei einer weiteren Bewegung des Dichtrahmens nach unten in Richtung der Basis federn die Rückhaltestifte dann entgegen der Vorspannung in die Aufnahmebuchsen 104 ein. Ferner kommt bei dieser Bewegung des Dichtrahmens die umlaufende Dichtung 22 am Dichtrahmen 7 zunächst mit der nach oben weisenden Seite der Photomaske 2 in Kontakt. Bei einer weiteren Bewegung des Dichtrahmens 7 nach unten wird die Dichtung 22 dann nach oben umgebogen. Durch eine weitere Bewegung des Dichtrahmens 7 in Richtung der Basis 5 kommt eine Unterseite der Dichtung 22 mit dem Seitenrand der Photomaske 2 in Kontakt und dichtet hiergegen ab. Diese Position der Dichtung wird beibehalten, bis der Dichtrahmen 7 auf der Basis 5 aufliegt. Der Dichtrahmen 7 wird dann, beispielsweise mittels Unterdruck, an der Basis 5 festgehalten und die Vorrichtung 50 gelöst und aus dem Bereich unmittelbar über dem Halter 1 entfernt.

Die Unterseite der Photomaske 2 bzw. ein Pellicle an der Unterseite der Photomaske 2 ist zu dem Zeitpunkt gegenüber der Umgebung abgedichtet. Nun kann ein Reinigungsmedium, wie beispielsweise eine Reinigungsflüssigkeit, ein Gas, oder auch ein Feststoff, wie zum Beispiel gefrorenes CO₂ auf die nach oben weisende Seite der Photomaske 2 aufgebracht werden, um diese zu reinigen. Durch die Abdichtung der Photomaske 2 am Seitenrand wird die untere Seite der Photomaske 2 bzw. ein daran befindliches Pellicle gegenüber dem Reinigungsmedium geschützt.

Wenn eine Flüssigkeit aufgebracht wird, kann nach dem Aufbringen der Reinigungsflüssigkeit und gegebenenfalls nach einem Spülen mit einer Spülflüssigkeit die entsprechende Oberseite der Photomaske 2 getrocknet werden. Dies kann beispielsweise durch eine rasche Rotation der Basis 5 und somit des Dichtrahmens 7 und der Photomaske 2 erreicht werden. Eine entsprechende Trocknung kann auch durch eine auf die Oberseite der Photomaske 2 gerichtete Gasströmung erreicht und/oder unterstützt werden.

Anschließend wird die Vorrichtung 50 wieder in Position über dem Dichtrahmen 7 gebracht und die Greifer 87 und 71 werden in Eingriff mit den Griffelementen 37 am Dichtrahmen 7 gebracht. Bei der Bewegung der Vorrichtung 50 in eine entsprechende Greifposition kontaktieren die Kontaktspitzen 108 der Rückhaltestifte 106 wieder die Oberseite der Photomaske 2, und die Rückhaltestifte 106 federn in die Aufnahmebuchsen 104 ein. Bei einer anschließenden nach oben gerichteten Bewegung der Vorrichtung 50 drücken die Rückhaltestifte 106 dann die Photomaske 2 gegen die Auflagen 16 der Auflageelemente 15, während der Dichtrahmen 7 über die Greifer 87, 71 der Vorrichtung angehoben wird. Dabei ist der Hub der Rückhaltestifte 106 sowie die entsprechende Vorspannung derselben ausreichend, um die Photomaske 2 sicher auf den Auflagen 16 der Auflageelementen 15 zu halten.

Wenn der Dichtrahmen 7 abgehoben und entfernt ist, kann anschließend auch die Photomaske 2 von den Auflageelementen 15 der Basis 5 entnommen werden.

Die Erfindung wurde zuvor anhand bevorzugter Ausführungsbeispiele erläutert, ohne auf die konkreten Ausführungsbeispiele beschränkt zu sein. Dem Fachmann werden sich innerhalb des Umfangs der Ansprüche unterschiedliche Modifikationen und Änderungen ergeben.

## Patentansprüche

1. Halter (1) zur Aufnahme und zum Schutz einer Seite einer Photomaske (2) mit oder ohne Pellicle, gegenüber einem Reinigungsmedium, wobei der Halter (1) Folgendes aufweist:
eine Basis (5) mit wenigstens drei Auflageelementen (15), die zur Aufnahme und zum Halten der Photomaske (2) beabstandet zu einem Boden (10) der Basis (5) angeordnet sind;
einen Dichtrahmen (7), mit einer Oberseite (24) und einer Unterseite (34), wobei die Unterseite (34) auf die Basis (5) aufsetzbar ist, und wobei der Dichtrahmen (7) eine Mittelöffnung (26) aufweist, die so bemessen ist,
dass sie die Photomaske (2) derart aufnehmen kann, dass zwischen einem Außenumfang der Photomaske (2) und einem Innenumfang der Mittelöffnung (26) ein Abstand verbleibt;
ein umlaufendes, elastisches Dichtelement (22) am Dichtrahmen (7), das sich vom Innenumfang der Mittelöffnung (26) schräg zur Oberseite (24) des Dichtrahmens (7) geneigt in die Mittelöffnung (26) hinein erstreckt,
wobei das Dichtelement (22) in einem unbelasteten Zustand einen Innenumfang besitzt, der kleiner ist als der Außenumfang der Photomaske (2) und in einem belasteten Zustand eine in der Mittelöffnung (26) aufgenommene Photomaske (2) umlaufend am Seitenrand kontaktiert.

2. Halter (1) nach Anspruch 1, wobei die Auflageelemente (15) so angeordnet sind, dass sie die Photomaske (2) ausschließlich in einem Kantenbereich, insbesondere in den Eckbereichen der Photomaske (2) kontaktieren, und/oder die Auflageelemente (15) jeweils eine oder zwei abgeschrägte Auflageflächen (16) aufweisen.

3. Halter (1) nach einem der vorhergehenden Ansprüche, wobei sich das Dichtelement (22) im unbelasteten Zustand gleichmäßig vom Innenumfang der Mittelöffnung (26) in diese hinein erstreckt, und zwar über einen Abstand von 2,5 bis 3,5 mm und bevorzugt über ungefähr 2,9 mm, und/oder das Dichtelement (22) im unbelasteten Zustand so bemessen ist, dass sie die Randbereiche einer hierzu zentrierten Photomaske (2) überlappt, und zwar um 0,4 bis 1 mm, vorzugsweise um 0,6 bis 0,8 mm.

4. Halter (1) nach einem der vorhergehenden Ansprüche, wobei das Dichtelement (22) eine Dicke im Bereich von 1 und 3 mm, vorzugsweise im Bereich 1,5 bis 2,5 mm und eine Shore Härte A im Bereich von 25° bis 75° aufweist und/oder das Dichtelement (22) vor Ihrer Installation im Dichtrahmen (26) im unbelasteten Zustand eine im Wesentlichen flache Konfiguration aufweist.

5. Halter (1) nach einem der vorhergehenden Ansprüche, wobei das Dichtelement (22) einen im Wesentlichen rechteckigen Innenumfang aufweist, wobei die Eckbereiche des Innenumfangs abgerundet sind und vorzugsweise einen Radius im Bereich von 2-4 mm, insbesondere von ungefähr 3 mm aufweisen und/oder das Dichtelement (22) eine im Wesentlichen rechteckige Konfiguration aufweist und an wenigstens zwei gegenüberliegenden Kantenbereichen jeweils am Außenumfang eine Montagelasche aufweist, und/oder das Dichtelement (22) gegenüber dem einzusetzenden Reinigungsmedium und/oder UV-Strahlung beständig ist.

6. Halter (1) nach einem der vorhergehenden Ansprüche, wobei der Dichtrahmen (7) ein Oberteil (20) und einem Unterteil (21) aufweist, die lösbar aneinander befestigt sind, und wobei das Dichtelement (22) zwischen Oberteil (20) und Unterteil (21) eingeklemmt ist, wobei das Oberteil (20) und das Unterteil (21) bevorzugt einen umlaufenden, zur Mittelöffnung (26) geöffneten Aufnahmeraum (40) für das Dichtelement (22) bilden, der sich zur Mittelöffnung (26) hin verjüngt und der zur Mittelöffnung (26) hin schräg zur Oberseite (24) des Dichtrahmens (26) hin geneigt ist, insbesondere im Mittel um ungefähr 29° zur Oberseite des Dichtrahmens hin geneigt ist, und/oder wobei der Aufnahmeraum (40) an seinem zur Mittelöffnung weisenden Ende eine Höhe besitzt, die bevorzugt kleiner ist als die Dicke des Dichtelements (22) und zwar insbesondere um 10 bis 20% kleiner ist als die Dicke des Dichtelements (22).

7. Halter (1) nach einem der vorhergehenden Ansprüche, wobei der Dichtrahmen (7) in einem Bereich oberhalb einer Anbringung des Dichtelements (22) eine sich radial zum Umfang des Dichtrahmens (7) erweiternde Schräge aufweist.

8. Halter (1) nach einem der vorhergehenden Ansprüche, wobei die Basis (5) eine Halteeinheit, insbesondere eine Unterdruckeinheit, zum lösbaren Halten des Dichtrahmens (7) aufweist, wobei bevorzugt die Basis (5) und/oder der Dichtrahmen (7) wenigstens eine zum jeweils anderen Element, d.h. dem Dichtrahmen (7) oder der Basis (5) weisende, umlaufende Dichtung aufweist und/oder wobei die Basis (5) und der Dichtrahmen (7) komplementäre Führungselemente aufweisen, welche bei einem Aufsetzen des Dichtrahmens (7) auf der Basis (5) eine Ausrichtung der Beiden zueinander bewirken.

9. Verfahren zum Reinigen einer Seite einer Photomaske (2), insbesondere einer Photomaske mit Pellicle, mit Folgenden Schritten:
Aufnehmen der Photomaske (2) in einem Halter nach einem der vorhergehenden Ansprüche, wobei die Photomaske (2) zunächst mit ihrer nicht zu reinigenden Seite zur Basis (5) weisend auf den Auflageelementen (15) abgelegt und anschließend der Dichtrahmen (7) derart auf die Basis (5) aufgesetzt wird, dass das elastische Dichtelement (22) die Photomaske (2) umlaufend am Seitenrand kontaktiert und abdichtet, wobei die zu reinigenden Seite der Photomaske (2) frei liegt;
Reinigen der zu reinigenden Seite der Photomaske (2) mit wenigstens einem Reinigungsmedium, das auf die zu reinigende Seite aufgebracht wird;
Abnehmen des Dichtrahmens (7) von der Basis (5) in der umgekehrten Richtung zum Aufsetzen, während die Photomaske (2) gegen die Auflageelemente (15) gedrückt wird; und
Abheben der Photomaske (2) von den Auflageelementen (15).

10. Verfahren nach Anspruch 9, wobei die Photomaske (2) so auf den Auflageelementen (15) abgelegt wird, dass nur Kantenbereiche, insbesondere Eckbereiche der Photomaske (2) die Auflageelemente kontaktieren, und/oder wobei beim Aufsetzen des Dichtrahmens (7) auf die Basis (5) das Dichtelement (22) zur Oberseite (24) des Dichtrahmens (7) hin verformt wird, sodass sich die Unterseite des Dichtelements (22) gegen den Seitenrand der Photomaske (2) legt und gegen diesen abdichtet, und wobei das Reinigungsmedium bevorzugt ein flüssiges Medium ist und die gereinigte Seite der Photomaske (2) vor dem Abnehmen des Dichtrahmens (7) von der Basis getrocknet wird.

11. Vorrichtung (50) zum Öffnen und Schließen eines Halters (1) nach einem der Ansprüche 1 bis 8, der folgendes aufweist:
wenigstens zwei beabstandete, zueinander weisende Greifer (71, 87), die zwischen einer geöffneten Position, in der sie den Dichtrahmen (7) frei dazwischen'aufnehmen können und einer geschlossenen Position, in der sie den Dichtrahmen (7) greifen können bewegbar sind;
eine Masken-Rückhalteeinheit (60) mit wenigstens einem Rückhaltestift (106), der räumlich derart zwischen den Greifern (71, 87) liegt, dass er mit der Mittelöffnung (26) im Dichtrahmen (7) ausgerichtet ist, wenn dieser zwischen den Greifern (71, 87) aufgenommen ist und der sich im Wesentlichen senkrecht zu einer Öffnungs-/Schließbewegungsrichtung der Greifer (71, 87) erstreckt, wobei der wenigstens eine Rückhaltestift (106) in seiner Erstreckungsrichtung bewegbar gehalten ist;
eine Bewegungseinheit, die sowohl mit den Greifern (71, 87) als auch der Rückhalteeinheit (60) gekoppelt ist, um diese gemeinsam zu bewegen.

12. Vorrichtung nach Anspruch 11, wobei der wenigstens eine Rückhaltestift (106) in einem Führungselement (104) aufgenommen und über ein Vorspanneinheit elastisch aus diesem heraus vorgespannt ist, wobei die Bewegung aus dem Führungselement (104) heraus durch wenigstens einen Anschlag begrenzt ist, oder
wobei der wenigstens eine Rückhaltestift (106) über einen steuerbaren Bewegungsmechanismus in seiner Erstreckungsrichtung bewegbar ist.

13. Vorrichtung nach Anspruch 11 oder 12, wobei der wenigstens eine Rückhaltestift (106) aus seiner Position zwischen den Greifern (71, 87) in eine neutrale Position bewegbar ist, in der er keine Rückhaltefunktion erfüllt.

14. Vorrichtung nach einem der Ansprüche 11 bis 13, wobei die Bewegungseinheit zwei beabstandete Arme aufweist, die jeweils wenigstens einen der Greifer (71, 87) tragen und sich wenigstens im Bereich der Greifer (71, 87) im Wesentlichen parallel in einer Längsrichtung erstrecken, wobei der Greifer (87) an wenigstens einem der Arme bevorzugt einen Greifbackenhalter mit einer Greifbacke aufweist, wobei der Greifbackenhalter drehbar um eine sich in Längsrichtung des entsprechenden Arms erstreckende erste Drehachse gelagert ist und wobei die Greifbacke drehbar um eine sich senkrecht zur Längsrichtung des entsprechenden Arms erstreckende zweite Drehachse am entsprechenden Greifbackenhalter gelagert ist, wobei die erste und zweite Drehachse bevorzugt im wesentlichen Senkrecht zueinander angeordnet sind.

15. Vorrichtung nach einem der Ansprüche 11 bis 14, wobei der Greifer an wenigstens einem der Arme einen Greifbackenhalter mit zwei in Längsrichtung des den Greifbackenhalter tragenden Arms beabstandete Greifbacken aufweist, wobei die Greifbacken in einer Grundstellung des Greifbackenhalters auf einer Linie im Wesentlichen parallel zum Arm ausgerichtet sind und wobei der Greifbackenhalter um eine sich senkrecht zur Längsrichtung des entsprechenden Arms erstreckende dritte Drehachse gelagert ist, die bevorzugt zu dem anderen Arm weist und die Vorrichtung bevorzugt ferner eine Vorspanneinheit aufweist, welche den Greifbackenhalter in die Grundstellung vorspannt.

## Claims

1. A holder (1) for receiving and for protecting one side of a photomask (2) with or without a pellicle from a cleaning medium, the holder (1) comprising:
a base (5) having at least three support elements (15), which are arranged for receiving and for holding the photomask (2) spaced from a bottom (10) of the base (5);
a sealing frame (7) having an upper side (24) and a lower side (34), wherein the lower side (34) is configured to be placed onto the base (5), and wherein the sealing frame (7) comprises a center opening (26), which is sized such that it may receive the photomask (2), such that a space remains between the outer circumference of the photo mask (2) and an inner circumference of the center opening (26);
a circumferential, elastic sealing element (22) at the sealing frame (7), which extends from the inner circumference of the center opening (26) into the center opening (26) in an inclined manner towards the upper side (24) of the sealing frame (7), wherein the sealing element (22) in a no load condition has an inner circumference, which is smaller than the outer circumference of the photomask (2), and in a load condition circumferentially contacts a photomask (2), which is received in the center opening (26), at its side surface.

2. The holder of claim 1, wherein the support elements (15) are arranged such that they contact the photomask (2) only at an edge, in particular at the corners of the photomask (2), and/or wherein the support elements (15) each have one or two inclined support surfaces (16).

3. The holder of any one of the preceding claims, wherein the seal element (22) in a no load condition extends from the inner circumference of the center opening (26) in a uniform manner into the same over a distance of 2.5 to 3.5 mm and preferably a distance of about 2.9 mm, and/or wherein the seal element (22) is sized such that in a no load condition it overlaps an edge area of a photomask (2), which is centered with respect to the seal element by about 0.4 to 1 mm, preferably by 0.6 to 0.8 mm.

4. The holder of any one of the preceding claims, wherein the seal element (22) has a thickness in the range of 1 and 3 mm, preferably in the range of 1.5 to 2.5 mm and a shore hardness A in the range of 25° to 75°, and/or wherein the seal element (22) has a substantially flat configuration in a no load condition prior to mounting the seal in the sealing frame (26).

5. The holder of any one of the preceding claims, wherein the seal element (22) has a substantially rectangular inner circumference, wherein the corners of the inner circumference are rounded and preferably have a radius in the range of 2 to 4 mm, in particular of about 3 mm, and/or wherein the seal element (22) has a substantially rectangular configuration and has a mounting lug on it outer circumference at at least two opposite edge regions, and/or wherein the seal element (22) is resistant to the cleaning medium to be used and/or UV radiation.

6. The holder of any one of the preceding claims, wherein the sealing frame (7) has an upper part (20) and a lower part (21), which are attached to each other in a detachable manner, and wherein the seal element (22) is clamped between the upper part (20) and the lower part (21), wherein the upper part (20) and the lower part (21) preferably form a circumferential receiving space (40) for the seal element (22), which is open towards the center opening (26), tapers towards the center opening (26) and extends towards the center opening (26) in an inclined manner towards the upper side (24) of the sealing frame (26), in particular on average inclined by approximately 29° towards the upper side of the sealing frame, and/or wherein the receiving space (40) has a height at its end facing the center opening, which is smaller than the thickness of the seal element (22) and in particular by 10 % to 20 % smaller than the thickness of the seal element (22).

7. The holder of any one of the preceding claims, wherein the sealing frame (7) has a slope in an area above the mounting location of the seal element (22), which widens towards the radial circumference of the sealing frame (7).

8. The holder of any one of the preceding claims, wherein the base (5) comprises a holder unit, in particular a vacuum or negative pressure unit, for holding the sealing frame (7) in a releasable manner to the base wherein preferably at least one of the base (5) and the sealing frame (7) comprises a circumferential seal, which faces towards the other element, and/or wherein the base (5) and the sealing frame (7) comprise complementary guide elements, which during placement of the sealing frame (7) onto the base (5) achieve alignment of the two elements which respect to each other.

9. A method for cleaning one side of a photomask (2), in particular of a photomask having a pellicle, the method comprising the following steps:
receiving the photomask (2) in a holder of any one of the preceding claims, wherein the photomask (2) is initially placed onto the support elements (15), such that its side not to be cleaned faces the base (5), and thereafter the sealing frame (7) is placed onto the base (5), such that the elastic seal element (22) contacts the photomask (2) circumferentially at its circumferential side surface and seals against the same, wherein the side of the photomask (2) to be cleaned is accessible;
cleaning the side of the photomask (2) to be cleaned with at least one cleaning medium, which is applied to the side to be cleaned;
removing the sealing frame (7) from the base (5) in the opposite direction to the placement of the sealing frame on the base, while pressing the photomask (2) against the support elements (15); and
removing the photomask (2) from the support elements (15).

10. The method of claim 9, wherein the photomask is placed onto the support elements (15) such that only edges, in particular corners of the photomask (2) contact the support elements, and/or wherein during placement of the sealing frame (7) onto the base (5), the sealing element (22) is deformed towards the upper side (24) of the sealing frame (7), such that the lower side of the sealing element (22) contacts the side surface of the photomask (2) and seals against the same, and wherein the cleaning medium is preferably a liquid medium and the cleaned side of the photomask (2) is dried prior to removing the sealing frame (7) from the base.

11. An apparatus (50) for opening and closing the holder (1) of any one of claims 1 to 8, the apparatus comprising:
at least two spaced grippers (71, 87), which face each other, which grippers are movable between an open position, in which they may freely receive the sealing frame (7) therebetween, and a closed position, in which they may grip the sealing frame (7);
a mask retention unit (60) having at least one retention pin (106), which is spatially arranged between the grippers (71, 87), such that it is aligned with the center opening (26) in the sealing frame (7), when the sealing frame is received between the grippers (71, 87), and which extends in substance perpendicular to an opening/closing direction of movement of the grippers (71, 87), wherein the at least one retention pin (106) is supported to be movable in its direction of extension;
a moving unit, which is coupled to both the grippers (71, 87) and the retention unit (106), in order to move the same conjointly.

12. The apparatus of claim 11, wherein the at least one retention pin (106) is received within a guide element (104) and is elastically biased out of the guide element via a biasing unit, wherein a movement of the retention pin out of the guide element (104) is limited by means of a stop, or
wherein the at least one retention pin (106) is movable in its direction of extension via a controllable moving mechanism.

13. The apparatus of claim 11 or 12, wherein the at least one retention pin (106) is movable from its position between the grippers (71, 87) into a neutral position, in which it cannot perform a retention function.

14. The apparatus of any one of claims 11 to 13, wherein the moving unit comprises two spaced arms, which each carry at least one gripper (71, 87) and which at least in the area of the grippers (71, 87) extend substantially parallel in a longitudinal direction, wherein the gripper (87) on at least one of the arms preferably comprises a gripper jaw holder having a gripper jaw, wherein the gripper jaw holder is rotationally supported around a first axis of rotation, which extends in a longitudinal direction of the respective arm, and wherein the gripper jaw is mounted on the respective gripper jaw holder to be rotational about a second axis of rotation, which extends perpendicular to the longitudinal extension of the respective arm, wherein the first and second axes of rotation are preferably arranged substantially perpendicular to each other.

15. The apparatus of any one of claims 11 to 14, wherein the gripper on at least one of the arms comprises a gripper jaw holder having two gripper jaws, which are spaced in a longitudinal direction of the arm supporting the gripper jaw holder, wherein the gripper jaws in a home position are aligned on a line which is substantially parallel to the arm, and wherein the gripper jaw holder is supported to be rotational around a third axis of rotation, which is perpendicular to the longitudinal direction of the respective arm and preferably points towards the other arm, and wherein the apparatus further preferably comprises a biasing unit, which biases the gripper jaw holder to its home position.

## Revendications

1. Support (1) destiné à recevoir et à protéger une face d'un photomasque (2) avec ou sans une pellicule provenant d'un milieu de nettoyage, le support (1) comprenant :
une base (5) ayant au moins trois éléments de support (15), qui sont disposés de sorte recevoir et à maintenir le photomasque (2) espacé d'un bas (10) de la base (5) ;
un cadre d'étanchéité (7) ayant un côté supérieur (24) et un côté inférieur (34), dans lequel le côté inférieur (34) est configuré pour être placé sur la base (5), et dans lequel le cadre d'étanchéité (7) comprend une ouverture centrale (26) qui est dimensionnée de sorte qu'elle peut recevoir le photomasque (2), de sorte qu'un espace demeure entre la circonférence extérieure du photomasque (2) et une circonférence intérieure de l'ouverture centrale (26) ;
un élément d'étanchéité élastique circonférentiel (22) au niveau du cadre d'étanchéité (7), qui s'étend à partir de la circonférence intérieure de l'ouverture centrale (26) dans l'ouverture centrale (26) de façon inclinée vers le côté supérieur (24) du cadre d'étanchéité (7), dans lequel l'élément d'étanchéité (22) dans un état déchargé a une circonférence intérieure, qui est inférieure à la circonférence extérieure du photomasque (2), et dans un état chargé contacte circonférentiellement un photomasque (2), qui est reçu dans l'ouverture centrale (26) au niveau de sa surface latérale.

2. Support selon la revendication 1, dans lequel les éléments de support (15) sont agencés de sorte qu'ils contactent le photomasque (2) uniquement au niveau d'une extrémité, en particulier au niveau des angles du photomasque (2), et/ou dans lequel les éléments de support (15) ont chacun une ou deux surfaces de support inclinées (16).

3. Support selon l'une quelconque des revendications précédentes, dans lequel l'élément de support (22) dans un état déchargé s'étend à partir de la circonférence intérieure de l'ouverture centrale (26) de façon uniforme dans celle-ci sur une distance de 2,5 à 3,5 mm et, de préférence, une distance d'environ 2,9 mm, et/ou dans lequel l'élément d'étanchéité (22) est dimensionné de sorte que dans un état déchargé il recouvre une surface de bord d'un photomasque (2), qui est centré par rapport à l'élément d'étanchéité d'environ 0,4 à 1 mm, de préférence de 0,6 à 0,8 mm.

4. Support selon l'une des revendications précédentes, dans lequel l'élément d'étanchéité (22) a une épaisseur dans la plage allant de 1 à 3 mm, de préférence dans la plage allant de 1,5 à 2,5 mm et une dureté Shore A dans la plage allant de 25° à 75°, et/ou dans lequel l'élément d'étanchéité (22) a une configuration sensiblement plate dans un état déchargé avant le montage du joint dans le cadre d'étanchéité (26).

5. Support selon l'une quelconque des revendications précédentes, dans lequel l'élément d'étanchéité (22) a une circonférence intérieure sensiblement rectangulaire, dans lequel les coins de la circonférence intérieure sont arrondis et, de préférence, ont un rayon dans la plage allant de 2 à 4 mm, en particulier d'environ 3 mm, et/ou dans lequel l'élément d'étanchéité (22) a une configuration sensiblement rectangulaire et a une patte de montage sur sa circonférence externe au niveau d'au moins deux régions de bord opposées, et/ou dans lequel l'élément d'étanchéité (22) est résistant au milieu de nettoyage à utiliser et/ou aux rayons UV.

6. Support selon l'une quelconque des revendications précédentes, dans lequel le cadre d'étanchéité (7) a une partie supérieure (20) et une partie inférieure (21), qui sont fixées l'une à l'autre de façon amovible, et dans lequel l'élément d'étanchéité (22) est serré entre la partie supérieure (20) et la partie inférieure (21), dans lequel la partie supérieure (20) et la partie inférieure (21) forment de préférence un espace de réception circonférentiel (40) pour l'élément d'étanchéité (22), qui est ouvert vers l'ouverture centrale (26), se rétrécit vers l'ouverture centrale (26) et s'étend vers l'ouverture centrale (26) d'une façon inclinée vers le côté supérieur (24) du cadre d'étanchéité (26), en particulier, incliné en moyenne d'environ 29° vers le côté supérieur du cadre d'étanchéité, et/ou dans lequel l'espace de réception (40) a une hauteur au niveau de son extrémité faisant face à l'ouverture centrale qui est inférieure à l'épaisseur de lequel l'élément d'étanchéité (22) et en particulier de 10 à 20 % inférieure à l'épaisseur de l'élément d'étanchéité (22).

7. Support selon l'une quelconque des revendications précédentes, dans lequel le cadre d'étanchéité (7) a une pente dans une région au-dessus de l'emplacement d'une fixation de l'élément d'étanchéité (22), qui s'élargit vers la circonférence radiale du cadre d'étanchéité (7).

8. Support selon l'une quelconque des revendications précédentes, dans lequel la base (5) comprend une unité de maintien, en particulier une unité à vide ou à pression négative, pour maintenir le cadre d'étanchéité (7) de façon amovible sur la base, dans lequel, de préférence, au moins un élément parmi la base (5) et le cadre d'étanchéité (7) comprend un joint circonférentiel, qui fait face à l'autre élément, et/ou dans lequel la base (5) et le cadre d'étanchéité (7) comprennent des éléments de guidage complémentaires qui, pendant le placement du cadre d'étanchéité (7) sur la base (5), permettent l'alignement des deux éléments l'un par rapport à l'autre.

9. Procédé destiné à nettoyer une face d'un photomasque (2), en particulier d'un photomasque ayant une pellicule, le procédé comprenant les étapes suivantes :
la réception du photomasque (2) dans un support selon l'une quelconque des revendications précédentes, dans lequel le photomasque (2) est placé initialement sur les éléments de support (15), de sorte que sa face qui n'est pas destinée à être nettoyée fasse face à la base (5), puis le cadre d'étanchéité (7) est placé sur la base (5) de sorte que l'élément d'étanchéité élastique (22) contacte le photomasque circonférentiellement au niveau de sa surface latérale circonférentielle et fasse joint contre celle-ci, dans lequel le côté du photomasque (2) à nettoyer est accessible ;
le nettoyage de la face du photomasque (2) à nettoyer avec au moins un milieu de nettoyage, qui est appliqué sur le côté à nettoyer ;
le retrait du cadre d'étanchéité (7) de la base (5) dans le sens inverse pour placer le cadre d'étanchéité sur la base, tout en appuyant le photomasque (2) contre les éléments de support (15) ; et
le retrait du photomasque (2) hors des éléments de support (15).

10. Procédé selon la revendication 9, dans lequel le photomasque est placé sur les éléments de support (15) de sorte que seuls des bords, en particulier des coins du photomasque (2) contactent les éléments de support, et/ou dans lequel, pendant le placement du cadre d'étanchéité (7) sur la base (5), l'élément d'étanchéité (22) est déformé vers le côté supérieur (24) du cadre d'étanchéité (7), de sorte que le côté inférieur de l'élément d'étanchéité (22) contacte la surface latérale du photomasque (2) et fasse joint contre celle-ci, et dans lequel le milieu de nettoyage est, de préférence, un milieu liquide et le côté nettoyé du photomasque (2) est séché avant de retirer le cadre d'étanchéité (7) de la base.

11. Appareil (50) destiné à ouvrir et fermer le support (1) selon l'une quelconque des revendications 1 à 8, l'appareil comprenant :
au moins deux pinces espacées (71, 87), qui se font face l'une à l'autre, lesquelles pinces sont mobiles entre une position ouverte, dans laquelle elles peuvent recevoir librement le cadre d'étanchéité (7) entre elles, et une position fermée, dans laquelle elles peuvent agripper le cadre d'étanchéité (7) ;
une unité de maintien de masque (60) ayant au moins une goupille de retenue (106), qui est agencée dans l'espace entre les pinces (71, 87), de sorte qu'elle soit alignée avec l'ouverture centrale (26) dans le cadre d'étanchéité (7), quand le cadre d'étanchéité est reçu entre les pinces (71, 87), et qui s'étend sensiblement perpendiculairement à une direction d'ouverture/fermeture du mouvement des pinces (71, 87), dans lequel ladite au moins une goupille de retenue (106) est maintenue de sorte à être mobile dans sa direction d'extension ;
une unité de mouvement, qui est couplée à la fois aux pinces (71, 87) et à l'unité de retenue (106), afin de déplacer celles-ci ensemble.

12. Appareil selon la revendication 11, dans lequel ladite au moins une goupille de retenue (106) est reçue dans un élément de guidage (104) et est sollicitée élastiquement hors de l'élément de guidage via une unité de sollicitation, dans lequel un mouvement de la goupille de rétention hors de l'élément de guidage (104) est limité au moyen d'une butée, ou dans lequel ladite au moins une goupille de retenue (106) est mobile dans sa direction d'extension via un mécanisme de déplacement contrôlable.

13. Appareil selon la revendication 11 ou 12, dans lequel ladite au moins une goupille de retenue (106) est mobile depuis sa position entre les pinces (71, 87) jusqu'à une position neutre, dans laquelle elle ne peut pas assurer de fonction de retenue.

14. Appareil selon l'une quelconque des revendications 11 à 13, dans lequel l'unité de déplacement comprend deux bras espacés, qui portent chacun au moins une pince et qui, au moins dans la région des pinces (71, 87), s'étendent sensiblement parallèlement dans une direction longitudinale, dans lequel la pince (87) sur au moins un des bras comprend, de préférence, un support de mâchoire de préhension ayant une mâchoire de préhension, dans lequel le support de mâchoire de préhension est monté en rotation autour d'un premier axe de rotation, qui s'étend dans une direction longitudinale du bras respectif, et dans lequel la mâchoire de préhension est montée sur le support de mâchoire de préhension de sorte à pouvoir tourner autour d'un deuxième axe de rotation, qui s'étend perpendiculairement à l'extension longitudinale du bras respectif, dans lequel les premier et deuxième axes de rotation sont agencés, de préférence, sensiblement perpendiculairement l'un à l'autre.

15. Dispositif selon l'une quelconque des revendications 11 à 14, dans lequel la pince sur au moins un des bras comprend un support de mâchoire de préhension ayant deux mâchoires de préhension, qui sont espacées dans une direction longitudinale du bras portant le support de mâchoire de préhension, dans lequel les mâchoires de préhension dans une position initiale sont alignées sur une ligne qui est sensiblement parallèle au bras, et dans lequel le support de mâchoire de préhension est monté de sorte à être en rotation autour d'un troisième axe de rotation, qui est perpendiculaire à la direction longitudinale du bras respectif et pointe, de préférence, vers l'autre bras, et dans lequel l'appareil comprend en outre, de préférence, une unité de sollicitation, qui sollicite le support de mâchoire de préhension vers sa position initiale.
